# EUROPÄISCHE PATENTSCHRIFT

(11) **EP 3 905 664 B1**
(45) Veröffentlichungstag und Bekanntmachung des Hinweises auf die Patenterteilung: **10.05.2023**
(21) Anmeldenummer: 21170637.9
(22) Anmeldetag: 27.04.2021
(51) Int. Cl.: H01L 27/146, H04N 25/60, H04N 25/77

(54) **BILDSENSOR**
IMAGE SENSOR
CAPTEUR D'IMAGE

(30) Priorität: 28.04.2020 DE 102020111562
(43) Veröffentlichungstag der Anmeldung: 03.11.2021
(73) Patentinhaber: Arnold & Richter Cine Technik GmbH & Co. Betriebs KG, 80807 München (DE)
(72) Erfinder: CIESLINSKI, Michael, 81927 München (DE)
(74) Vertreter: Manitz Finsterwald Patent- und Rechtsanwaltspartnerschaft mbB

(56) Entgegenhaltungen:
- US-A1- 2010 060 764
- US-A1- 2012 097 842
- US-A1- 2013 082 313

## Beschreibung

Die Erfindung betrifft einen Bildsensor für elektronische Kameras, insbesondere CMOS-Bildsensor, mit einer Vielzahl von Pixeln zur Erzeugung von belichtungsabhängigen Signalen.

Elektronische Kameras werden beispielsweise als Bewegtbildkameras verwendet, um Bewegtbildsequenzen aufzunehmen, die später im Kino vorgeführt werden. Dabei ist es wichtig, dass diese Kameras eine hohe Bildqualität aufweisen. Insbesondere werden bei der Nachbearbeitung die aufgenommenen Bilder noch in Helligkeit, Kontrast und Farbe verändert, und das Endprodukt - die bearbeitete Bewegtbildsequenz bzw. der Film - wird im Kino auf eine große Leinwand projiziert.

Elektronische Kameras verwenden typischerweise Bildsensoren aus Silizium in CMOS- oder CCD-Technologie. Bei derartigen Bildsensoren bilden die Pixel ein Bildfeld, und sie sind in Zeilen und Spalten angeordnet. Die Pixel können mit einem Farbfiltermuster (Color Filter Array, CFA) versehen sein, um eine unterschiedliche spektrale Empfindlichkeit zu besitzen. Jedes Pixel umfasst zumindest: ein lichtempfindliches Element, um aus einfallendem Licht elektrische Ladung zu erzeugen; ferner einen Ausleseknoten; ein Transfer-Gate, um wahlweise das lichtempfindliche Element mit dem Ausleseknoten zu koppeln und erzeugte Ladung von dem lichtempfindlichen Element zu dem Ausleseknoten zu transferieren; einen Wandler-Transistor, um die an dem Ausleseknoten vorhandene Ladung in ein Spannungssignal an einem Signalausgang umzusetzen; und einen Auswahl-Schalter, der mit dem Signalausgang des Wandler-Transistors über eine Ausgangsleitung verbunden ist, um den Signalausgang des Wandler-Transistors wahlweise mit einer zugeordneten Ausleseleitung (z.B. Spaltenleitung) des Bildsensors zu koppeln. Der Ausleseknoten des Pixels ist somit generell durch die Verbindung zwischen einem Ausgang des Transfer-Gate und einem Eingang (z.B. Gate-Anschluss) des Wandler-Transistors gebildet.

Das jeweilige Pixel kann auch einen Rücksetz-Schalter umfassen, um wahlweise den Ausleseknoten mit einem Rücksetz-Potential zu koppeln. Ein derartiger Bildsensor kann ferner eine Steuereinrichtung zur Erzeugung von Steuersignalen für das jeweilige Transfer-Gate, den jeweiligen Auswahl-Schalter und ggf. den jeweiligen Rücksetz-Schalter der Pixel umfassen, um wahlweise Bildsignale (oder Bildsignale und Referenzsignale) aus dem Ausleseknoten auszulesen. Der Wandler-Transistor kann einen Impedanzwandler bilden, der in Abhängigkeit von einer an seinem Eingang vorhandenen Ladungsmenge ein Spannungssignal an seinem Signalausgang erzeugt. Die Ausleseleitungen des Bildsensors können mit einem jeweiligen Ausleseverstärker (z.B. Spaltenverstärker, Zeilenverstärker) verbunden sein, um die nacheinander auf die zugeordnete Ausleseleitung geschalteten Spannungssignale der Pixel zu verstärken. Mehrere Ausleseleitungen des Bildsensors können ferner mit einem Signalbus verbunden sein, der zu einem oder mehreren Ausgangsverstärker(n) führt, um die (ggf. bereits vorverstärkten) Spannungssignale mehrerer Ausleseleitungen zu verstärken. Die Pixel des Bildsensors werden beispielsweise zeilenweise adressiert, und die Signale der Pixel werden zu den Ausleseverstärkern am Rand des Bildfelds und von dort zum Ausgang geleitet, digitalisiert und optional mit Kalibrierdaten verrechnet.

Um auch bei schlechten Lichtverhältnissen Bewegtbildsequenzen aufnehmen zu können und um die Kosten für künstliche Beleuchtungsmaßnahmen an einem Filmset gering zu halten, ist es erwünscht, dass die Bildsensoren elektronischer Kameras eine hohe Lichtempfindlichkeit aufweisen.

Aus US 2012/097842 A1 ein Bildsensor gemäß dem Oberbegriff des Anspruchs 1 bekannt. Aus US 2010/060764 A1 und US 2013/082313 A1 sind weitere Bildsensoren mit Abschirmstrukturen bekannt, um parasitäre Kapazitäten zu verringern.

Es ist Aufgabe der vorliegenden Erfindung, einen Bildsensor mit verbesserter Lichtempfindlichkeit zu schaffen.

Der vorliegenden Erfindung liegen die folgenden Überlegungen zugrunde.

Die Lichtempfindlichkeit wird wesentlich durch das Rauschen des Bildsensors bestimmt. Das Rauschen des Bildsensors setzt sich im Wesentlichen aus dem Rauschen des jeweiligen Pixels und dem Rauschen des Auslesepfads zusammen. Das Rauschen des Auslesepfads lässt sich durch geeignete Auslegung auf Werte von z.B. 80 µV reduzieren, so dass es gegenüber dem Rauschen des Pixels von z.B. 180 µY eine lediglich untergeordnete Rolle spielt.

Die Rausch-Spannung in dem jeweiligen Pixel wird wesentlich durch den Wandler-Transistor (z.B. Source-Folger, SF) bestimmt. Das Rauschen des Pixels ist das Verhältnis zwischen der Signal-Spannung, die ein Elektron verursacht, und der Rauschspannung des Wandler-Transistors (SF). Um das Rauschen zu reduzieren, muss also entweder die Rauschspannung des Wandler-Transistors verringert werden, oder die Signal-Spannung, die ein Elektron verursacht, muss erhöht werden.

Wenn ein Photon in dem lichtempfindlichen Element (z.B. Pinned-Diode) absorbiert wird, erzeugt es dort ein Elektron. Durch kurzzeitiges Ansteuern des Transfer-Gate des Pixels wird dieses Elektron zu dem Ausleseknoten (z.B. Floating Diffusion, FD) transferiert (wobei bei einem Auslesevorgang typischerweise eine Vielzahl von photoelektrisch erzeugten Elektronen transferiert werden). Die Ladung dieses jeweiligen Elektrons wirkt auf die Kapazität des Ausleseknotens (FD) und bewirkt dort eine Spannungsänderung. Bei der Kapazität des Ausleseknotens handelt es sich im Wesentlichen um eine parasitäre Kapazität. Die von dem jeweiligen Elektron verursachte Spannungsänderung ist umgekehrt proportional zur Kapazität des Ausleseknotens. Um die von einem Elektron verursachte Signal-Spannung zu erhöhen und hierdurch das Rauschen des Pixels zu reduzieren, kann also versucht werden, die Kapazität des Ausleseknotens (FD) zu verringern.

Bei üblichen Bildsensoren kann der Ausleseknoten des jeweiligen Pixels eine Kapazität von beispielsweise 1,6 fF (Femtofarad) aufweisen, wodurch eine Spannungsänderung von 100 µY pro Elektron erreicht wird. Die Kapazität des Ausleseknotens (FD) setzt sich im Wesentlichen aus drei Komponenten zusammen:
a) Kapazität des FD-Gebiets;
b) Kapazität des Eingangs (Gate) des Wandler-Transistors (SF); und
c) Kapazität der Verbindung von dem Ausleseknoten (FD) zum Eingang (Gate) des Wandler-Transistors.

Die Kapazität a) des FD-Gebiets konnte durch geringere Dosierung der Implants im Laufe der letzten Jahre immer weiter reduziert werden und hat somit an der Kapazität des Ausleseknotens (FD) nur noch einen untergeordneten Anteil von beispielweise 0,12 fF, entsprechend 7,5 %.

Die Kapazität b) des Eingangs des Wandler-Transistors setzt sich bei einem Source-Folger-Transistor aus der Gate-Drain-Kapazität und der Gate-Source-Kapazität zusammen. Die Gate-Drain-Kapazität resultiert im Wesentlichen aus der Überlappung des Gates mit dem Drain-Anschluss und kann bei einer angenommenen Größe des Source-Folger-Transistors von 0,8 µm x 1,1 µm z.B. 0,24 fF betragen. Die Gate-Source-Kapazität setzt sich aus der Summe der Kapazitäten von Gate-Fläche und der Überlappung zum Source-Anschluss zusammen und kann bei der angenommenen Größe des Source-Folger-Transistors nominell z.B. 3,1 fF betragen. Da der Source-Anschluss des Source-Folger-Transistors beim Auslesen des Pixels an die Ausleseleitung (z.B. Spaltenleitung) angeschlossen wird und diese der Ladung bzw. der entsprechenden Spannung an dem Ausleseknoten (FD) folgt, wird nur ein Teil der Source-Kapazität wirksam. Bei einer Spannungsverstärkung (Gain) des Source-Folger-Transistors von beispielsweise 92,3 % werden nur 7,7 % der Source-Kapazität wirksam, was einer effektiven Gate-Source-Kapazität von 0,24 fF entspricht. Die gesamte effektive Kapazität b) des Eingangs (Gate) des Wandler-Transistors (SF) beträgt demnach in diesem Beispiel 0,48 fF, was 30 % der gesamten Kapazität des Ausleseknotens (FD) entspricht.

Die Kapazität c) der Verbindung von dem Ausleseknoten (FD) zum Eingang (Gate) des Wandler-Transistors kann typischerweise Werte von 1 fF annehmen und dominiert damit die typische Kapazität des Ausleseknotens (FD) (1,6 fF) mit einem Anteil von 62,5 %.

Um die Empfindlichkeit des Bildsensors deutlich zu steigern, muss also die Kapazität der von dem Ausleseknoten (FD) zum Eingang (Gate) des Wandler-Transistors führenden Verbindung verringert werden, da diese den größten Anteil an der Kapazität des Ausleseknotens (FD) hat.

Die genannte Aufgabe wird durch einen Bildsensor mit den Merkmalen des Anspruchs 1 gelöst.

Bei dem Bildsensor ist vorgesehen, dass das jeweilige Pixel eine elektrisch leitende Abschirmstruktur aufweist, die den Ausleseknoten des Pixels zumindest teilweise umgibt und die auf ein elektrisches Potential gesetzt oder setzbar ist, das von dem Spannungssignal des Wandler-Transistors abhängt.

Die Abschirmstruktur liegt zum einen dauerhaft oder zumindest temporär auf einem elektrischen Potential, das entsprechend dem elektrischen Potential am Signalausgang des Wandler-Transistors des jeweiligen Pixels variiert, und ist zum anderen benachbart zu dem Ausleseknoten des Pixels angeordnet. Insbesondere kann die Abschirmstruktur während eines Schließens des Auswahl-Schalters auf ein dem Spannungssignal des Wandler-Transistors entsprechendes Potential gesetzt sein, und insbesondere auch bereits vor dem Schließen des Auswahl-Schalters, während der Ausleseknoten sich mit elektrischer Ladung aus dem lichtempfindlichen Element füllt.

Insbesondere kann die Abschirmstruktur bezogen auf eine Draufsicht auf das jeweilige Pixel den Ausleseknoten des Pixels zumindest teilweise umgeben. Die Abschirmstruktur kann zumindest teilweise innerhalb der Ebene, in welcher der Ausleseknoten liegt, angeordnet sein, um den Ausleseknoten (oder einen Teil hiervon) teilweise oder vollständig zu umgeben. Alternativ oder zusätzlich kann die Abschirmstruktur zumindest teilweise innerhalb einer zu der Ebene des Ausleseknotens versetzten Ebene benachbart zu dem Ausleseknoten angeordnet sein, um den Ausleseknoten (oder einen Teil hiervon) teilweise oder vollständig zu umgeben.

Die Abschirmstruktur kann somit bewirken, dass das elektrische Potential in der Umgebung des Ausleseknotens (insbesondere in der Umgebung der Verbindung von dem Ausgang des Transfer-Gate zum Eingang (Gate) des Wandler-Transistors) dem Potential am Signalausgang des Wandler-Transistors folgt, welches von der Ladung im Ausleseknoten abhängt. Hierdurch wird der Fußpunkt des durch die Kapazität des Ausleseknotens gebildeten Kondensators entsprechend der im Ausleseknoten vorhandenen Ladung angehoben. Folglich werden die Potentialdifferenz und somit die wirksame Kapazität des Ausleseknotens (FD) verringert. Die von einem Elektron im Ausleseknoten verursachte Signal-Spannung wird dementsprechend erhöht.

Mit anderen Worten folgt aufgrund der Abschirmstruktur das elektrische Potential in der Umgebung des Ausleseknotens zumindest temporär der am Signalausgang des Wandler-Transistors erzeugten Spannung, welche wiederum von der Ladungsansammlung im Ausleseknoten abhängt. Hierdurch wird der überwiegende Teil der (parasitären) Kapazität des Ausleseknotens nicht wirksam. Bezogen auf die vorstehend genannten beispielhaften Werte bedeutet dies bei einer Verstärkung (Gain) des Wandler-Transistors bzw. Source-Folger-Transistors von z.B. 92,3 %, dass bei einer Kapazität der Verbindung von dem Ausleseknoten (FD) zum Eingang (Gate) des Wandler-Transistors von 1 fF nur 0,077 fF wirksam werden.

Durch das Einbetten der Verbindung vom Ausleseknoten zum Eingang des Wandler-Transistors in eine Abschirmstruktur erhöht sich die nominelle Kapazität zwar beispielsweise von 1 fF auf 2 fF an, nämlich wegen der geringen Abstände zu der umgebenden Abschirmstruktur. Die wirksame Kapazität reduziert sich jedoch auch unter Berücksichtigung dieses Effekts signifikant, nämlich aufgrund der Verbindung der Abschirmstruktur mit dem elektrischen Potential des Signalausgangs des Wandler-Transistors auf beispielsweise 0,144 fF (= 2 x 0,077 fF).

Die gesamte effektive Kapazität des Ausleseknotens eines Pixels mit Abschirmstruktur kann bei dem zuvor angegebenen Beispiel somit von 1,6 fF auf 0,744 fF verringert werden (= 0,12 fF + 0,48 fF + 0,144 fF), also auf 46,5 % des Ausgangswerts. Die von einem Elektron verursachte Signal-Spannung kann folglich von 100 µV auf 215 µV ansteigen. Dadurch wird das Rauschen effektiv mehr als halbiert, nämlich von 1,6 Elektronen (160 µV Rauschen bei 100 µV/e-) auf 0,75 Elektronen. Das deutlich geringere Rauschen führt zu einer wesentlich gesteigerten Lichtempfindlichkeit.

Die vorstehend genannten Zahlenwerte sind beispielhaft zu verstehen. Der durch die Abschirmstruktur erzielte Effekt kann auch stärker oder schwächer ausfallen.

Die Erfindung kann auch bei einer Pixelarchitektur und/oder Auslesearchitektur zum Einsatz gelangen, die komplexer ist/sind als vorstehend genannt. Beispielsweise kann innerhalb des jeweiligen Pixels ein Überlauf-Kondensator mit einem zusätzlichen Transfer-Gate vorgesehen sein, wie nachfolgend noch erläutert wird. Bei einigen Ausführungsformen kann das jeweilige Pixel ein einziges lichtempfindliches Element aufweisen; bei anderen Ausführungsformen kann das jeweilige Pixel auch mehrere lichtempfindliche Elemente aufweisen, die über ein jeweiliges Transfer-Gate mit einem gemeinsamen Ausleseknoten (FD) verbunden koppelbar sind (sogenanntes "sharing") und/oder die (zeitlich alternierend) einem gemeinsamen Wandler-Transistor zugeordnet sind. Ferner ist es möglich, dass der Bildsensor für jede Spalte oder Zeile von Pixeln mehrere Ausleseleitungen aufweist (z.B. mehrere Spaltenleitungen für jede Spalte von Pixeln), oder dass für jedes Pixel mehrere Kanäle mit unterschiedlichen Verstärkungsfaktoren vorgesehen sind.

Sofern im Zusammenhang mit der Erfindung auf eine elektrische Spannung oder ein elektrisches Potential Bezug genommen wird, ist zu berücksichtigen, dass die elektrische Spannung als Differenz zwischen einem ersten Potential (z.B. einem erzeugten oder betrachteten Potential) und einem zweiten Potential (z.B. einem Bezugspotential) definiert ist. Insofern können die beiden Begriffe, sofern das jeweilige Bezugspotential gegeben ist, letztlich gleichbedeutend sein oder gleichbedeutend verwendet werden.

Sofern im Zusammenhang mit der Erfindung auf Leitungen in dem Bildsensor Bezug genommen wird, sind hierunter elektrisch leitende Verbindungen zu verstehen, die insbesondere auf oder innerhalb eines Substrats gebildet sein können, beispielsweise durch Metallisierung oder Dotierung.

Im Folgenden werden weitere Ausführungsformen der Erfindung erläutert.

Bei einigen Ausführungsformen kann die Abschirmstruktur mit dem Signalausgang des Wandler-Transistors (z.B. Source-Anschluss) dauerhaft verbunden sein. Bei anderen Ausführungsformen kann die Abschirmstruktur mit dem Signalausgang des Wandler-Transistors lediglich temporär koppelbar sein, insbesondere durch temporäres Schließen eines zugeordneten Schalters. Hierbei kann ein wahlweises Koppeln der Abschirmstruktur mit dem Signalausgang des Wandler-Transistors zumindest während eines Schließens des Auswahl-Schalters des jeweiligen Pixels erfolgen, und insbesondere auch bereits vor dem Schließen des Auswahl-Schalters, nämlich während der Ausleseknoten über das Transfer-Gate mit elektrischer Ladung aus dem lichtempfindlichen Element befüllt wird. Die Steuereinrichtung des Bildsensors (z.B. interner oder externer Microcontroller) kann dazu ausgebildet sein, die Schalter des Bildsensors in einer entsprechenden Abfolge anzusteuern.

In den vorgenannten Fällen kann die Abschirmstruktur direkt oder indirekt mit dem Signalausgang des Wandler-Transistors verbunden oder koppelbar sein. Eine direkte Verbindung oder Kopplung kann insbesondere durch durchgehende elektrische Leitungen innerhalb des jeweiligen Pixels gebildet sein. Eine indirekte Verbindung oder Kopplung mit dem Signalausgang des Wandler-Transistors kann beispielsweise über einen zugeordneten Impedanzwandler und/oder über sonstige, insbesondere aktive, elektronische Komponenten erfolgen, wie nachfolgend noch erläutert wird.

Beispielsweise kann die Abschirmstruktur direkt mit dem Signalausgang des Wandler-Transistors verbunden sein, insbesondere über eine Verbindungsleitung, wobei eine solche Verbindungsleitung vollständig innerhalb des jeweiligen Pixels oder teilweise auch außerhalb des jeweiligen Pixels verlaufen kann.

Bei einigen Ausführungsformen kann der Auswahl-Schalter des jeweiligen Pixels mit dem Signalausgang des Wandler-Transistors über eine Ausgangsleitung verbunden sein, wobei die Abschirmstruktur über die Ausgangsleitung (und optional auch über eine zu der Ausgangsleitung führende Verbindungsleitung) mit dem Signalausgang des Wandler-Transistors verbunden sein kann, insbesondere über lediglich einen Teil der Ausgangsleitung. Hierdurch ist eine direkte Verbindung mit kurzen Leitungswegen möglich, um die Abschirmstruktur auf das elektrische Potential des Signalausgangs zu setzen. Insbesondere kann bei einer solchen Ausführungsform eine dauerhafte Verbindung vorgesehen sein, wobei generell jedoch auch eine schaltbare Kopplung möglich ist. Nachfolgend werden noch vorteilhafte Ausführungsformen einer kompakten Pixelarchitektur erläutert, bei denen die Verbindungsleitung zwischen der Abschirmstruktur und dem Signalausgang des Wandler-Transistors vollständig innerhalb des jeweiligen Pixels verläuft und der Ausleseknoten einen Brückenabschnitt umfasst, welcher von der Abschirmstruktur umgeben ist. Bei anderen Ausführungsformen kann die Abschirmstruktur über die gesamte (zwischen dem Signalausgang des Wandler-Transistors und dem Auswahl-Schalter verlaufende) Ausgangsleitung mit dem Signalausgang des Wandler-Transistors verbunden oder koppelbar sein, wie nachfolgend erläutert wird.

Bei einigen Ausführungsformen kann die Abschirmstruktur zumindest über die zugeordnete Ausleseleitung des Bildsensors (z.B. Spaltenleitung oder Zeilenleitung) und den Auswahl-Schalter des jeweiligen Pixels mit dem Signalausgang des Wandler-Transistors koppelbar sein. Es ist also auch möglich, dass das elektrische Potential der Abschirmstruktur dem elektrischen Potential am Signalausgang des Wandler-Transistors des jeweiligen Pixels über eine Verbindung folgt, die außerhalb des jeweiligen Pixels verläuft. Die Abschirmstruktur kann insbesondere dann über die Ausleseleitung mit dem Signalausgang des Wandler-Transistors gekoppelt sein, wenn der Auswahl-Schalter des jeweiligen Pixels geschlossen ist. Insbesondere kann hierbei vorgesehen sein, dass zu diesem Zeitpunkt - also während der Auswahl-Schalter des jeweiligen Pixels geschlossen ist, um den Signalausgang des Wandler-Transistors mit der zugeordneten Ausleseleitung zu koppeln - kein Auswahl-Schalter eines anderen dieser Ausleseleitung zugeordneten Pixels geschossen ist. Hierdurch können gegenseitige Beeinflussungen zwischen den Pixeln verhindert werden, insbesondere wenn keine weitere Entkopplung zwischen den Abschirmstrukturen der Pixel und der zugeordneten Ausleseleitung vorgesehen ist.

Bei derartigen Ausführungsformen, also wenn die Abschirmstruktur über die zugeordnete Ausleseleitung des Bildsensors mit dem Signalausgang des jeweiligen Wandler-Transistors koppelbar ist, kann die Kopplung indirekt über einen Impedanzwandler erfolgen. Hierdurch kann verhindert werden, dass die Kapazität der Ausleseleitung (z.B. Spaltenleitung) durch die verbundenen Abschirmstrukturen der zugeordneten Pixel unerwünscht erhöht wird und das jeweilige Spannungssignal der Wandler-Transistoren oder deren zeitliches Verhalten (z.B. Dauer des Einschwingens) beeinträchtigt.

Für jeweils eine Ausleseleitung (z.B. Spaltenleitung) kann ein gemeinsamer derartiger Impedanzwandler vorgesehen sein. Der Impedanzwandler kann beispielsweise am Rande des Pixelfelds angeordnet sein. Ein jeweiliger Impedanzwandler kann somit insbesondere für mehrere oder sämtliche Pixel einer Spalte vorgesehen sein. Ein Eingang des Impedanzwandlers kann mit der Ausleseleitung verbunden sein. Der Eingang des Impedanzwandlers kann somit ferner mit dem Eingang einer Spaltenausleseschaltung (z.B. Spaltenverstärkerschaltung) oder Zeilenausleseschaltung verbunden sein. Zumindest ein Abschnitt einer Verbindungsleitung von dem Ausgang des Impedanzwandlers zu der jeweiligen Abschirmstruktur kann im Wesentlichen parallel und insbesondere benachbart zu der zugeordneten Ausleseleitung (z.B. Spaltenleitung) verlaufen und somit während inaktiver Zeiten auch zur gegenseitigen Entkopplung mehrerer benachbarter Ausleseleitungen genutzt werden.

Bei einigen Ausführungsformen kann der Impedanzwandler als ein Spannungsfolger konfiguriert sein.

Bei einigen Ausführungsformen kann der Impedanzwandler dazu ausgebildet sein, das jeweilige Eingangssignal, insbesondere das empfange Spannungssignal des jeweiligen Wandler-Transistors, zu verstärken, um eine erhöhte Abhängigkeit des elektrischen Potentials der Abschirmstruktur von dem Spannungssignal des Wandler-Transistors bzw. von der Ladungsmenge im Ausleseknoten (FD) zu bewirken. Der Impedanzwandler kann somit als ein Feedback-Verstärker wirksam sein. Hierdurch kann eine besonders effektive Abschirmungswirkung erreicht werden. Der Impedanzwandler kann beispielsweise eine Verstärkung von ca. 108 % aufweisen, so dass sich zusammen mit einer Verstärkung des Wandler-Transistors (SF) von beispielsweise 92 % eine Gesamt-Verstärkung von ca. 100 % ergibt. Die Verstärkung des Impedanzwandlers bzw. Feedback-Verstärkers kann auch noch größer gewählt werden, um zusätzliche Anteile der Kapazität des Ausleseknotens zu kompensieren; die Verstärkung darf allerdings nicht zu hoch sein, damit das System nicht instabil wird und etwa zu schwingen beginnt.

Bei einigen Ausführungsformen mit Impedanzwandler kann eine derartige Verstärkung des Spannungssignals des jeweiligen Wandler-Transistors schaltbar sein, und/oder der Impedanzwandler kann dazu ausgebildet sein, das Spannungssignal des Wandler-Transistors mit einer abnehmenden Verstärkungskennlinie zu verstärken (also mit einer degressiven Proportionalität zwischen Eingangssignal und Ausgangssignal des Impedanzwandlers). Hierdurch können unterschiedliche Belichtungssituationen bzw. unterschiedliche Ladungsmengen in dem Ausleseknoten des jeweiligen Pixels besser berücksichtigt werden, beispielsweise um das elektrische Potential der Abschirmstruktur bei geringen Ladungsmengen in dem Ausleseknoten stärker anzuheben (stärkere Abhängigkeit von dem Spannungssignal am Ausgang des Wandler-Transistors, geringere Kapazität des Ausleseknotens) als bei größeren Ladungsmengen in dem Ausleseknoten.

Bei derartigen Ausführungsformen mit Impedanzwandler (insbesondere auch in einer Konfiguration als Verstärker) kann eine Verbindungsleitung zwischen dem Ausgang des Impedanzwandlers und der jeweiligen Abschirmstruktur vorgesehen sein. Eine solche Verbindungsleitung kann schaltbar sein. Insbesondere kann vorgesehen sein, dass die Abschirmstruktur über einen Koppel-Schalter mit einem Ausgang des Impedanzwandlers koppelbar ist, um die Abschirmstruktur wahlweise mit dem Ausgang des Impedanzwandlers zu koppeln. Hierbei kann ein erster Abschnitt der Verbindungsleitung für mehrere Pixel (z.B. mehrere oder sämtliche Pixel einer Spalte) gemeinsam genutzt werden, und ein jeweiliger zweiter Abschnitt der Verbindungsleitung (zwischen dem jeweiligen Koppel-Schalter und der jeweiligen Abschirmstruktur) ist einem jeweiligen Pixel zugeordnet.

Generell kann die Abschirmstruktur über einen Koppel-Schalter direkt oder indirekt mit dem Signalausgang des jeweiligen Wandler-Transistors koppelbar sein, damit das elektrische Potential der Abschirmstruktur nur zu geeigneten bzw. notwendigen Zeitpunkten dem Spannungssignal des Wandler-Transistors folgt. Bei einigen Ausführungsformen kann ein derartiger Koppel-Schalter gemeinsam mit dem Auswahl-Schalter des jeweiligen Pixels ansteuerbar sein, um die Abschirmstruktur wahlweise mit dem Signalausgang zu koppeln. Insbesondere können der Koppel-Schalter und der Auswahl-Schalter des jeweiligen Pixels an eine gemeinsame Steuerleitung angeschlossen sein. Somit kann bei einfacher Ansteuerung erreicht werden, dass die Abschirmstruktur lediglich dann mit dem Ausgang des Impedanzwandlers verbunden wird und als erwünschte Abschirmung, jedoch auch als kapazitive Last wirksam wird, wenn tatsächlich ein Spannungssignal des jeweiligen Pixels ausgelesen wird. Alternativ kann für den Koppel-Schalter jedoch auch eine separate Steuerleitung für eine unabhängige Steuerung vorgesehen sein. In sämtlichen der genannten Fälle kann die Steuerung des Koppel-Schalters durch die bereits genannte Steuereinrichtung des Bildsensors erfolgen, die auch die erforderlichen Steuersignale für das jeweilige Transfer-Gate, den jeweiligen Auswahl-Schalter und ggf. den jeweiligen Rücksetz-Schalter der Pixel erzeugt.

Bei einigen Ausführungsformen, insbesondere wenn die Abschirmstruktur über einen Koppel-Schalter direkt oder indirekt mit dem Signalausgang des jeweiligen Wandler-Transistors koppelbar ist, kann die Abschirmstruktur über einen weiteren Koppel-Schalter mit einem elektrischen Bezugspotential koppelbar sein. Hierdurch kann erreicht werden, dass die Abschirmstruktur, wenn der weitere Koppel-Schalter geschlossen ist, auf einem definierten festen Potential liegt, um unerwünschte Beeinflussungen des Pixels und insbesondere des Ausleseknotens durch ein undefiniertes bzw. schwebendes elektrisches Potential zu vermeiden. Bei dem Bezugspotential kann es sich insbesondere um das Massepotential oder eine Versorgungsspannung des Bildsensors handeln.

Bei einigen Ausführungsformen können der Bildsensor und insbesondere eine Steuereinrichtung des Bildsensors dazu ausgebildet sein, dass der genannte Koppel-Schalter und der genannte weitere Koppel-Schalter lediglich alternativ zueinander geschlossen werden, damit die jeweilige Abschirmstruktur lediglich entweder (direkt oder indirekt) mit dem Spannungssignal des Wandler-Transistors oder mit dem elektrischen Bezugspotential gekoppelt wird.

Bei einigen Ausführungsformen kann die Abschirmstruktur den Ausleseknoten an wenigstens drei Seiten umgeben. Hierdurch kann eine signifikante Verringerung der wirksamen Kapazität des Ausleseknotens erreicht werden. Die Abschirmstruktur kann den Ausleseknoten an wenigstens drei Seiten innerhalb einer Anordnungsebene umgeben, in der auch der Ausleseknoten liegt. Bei einigen Ausführungsformen kann die Abschirmstruktur den Ausleseknoten an vier Seiten innerhalb einer Anordnungsebene umgeben, in der auch der Ausleseknoten liegt. Bei einigen Ausführungsformen kann die Abschirmstruktur den Ausleseknoten an fünf oder sechs Seiten umgeben, nämlich innerhalb einer Anordnungsebene, in der auch der Ausleseknoten liegt, sowie oberhalb und/oder unterhalb der Anordnungsebene.

Bei einigen Ausführungsformen kann die Abschirmstruktur umfänglich geschlossen sein, um eine besonders starke Verringerung der wirksamen Kapazität des Ausleseknotens zu erreichen.

Bei einigen Ausführungsformen kann die Abschirmstruktur eine O-Form aufweisen. Insbesondere kann die Abschirmstruktur einen Abschirmring bilden.

Bei einigen Ausführungsformen kann die Abschirmstruktur umfänglich geöffnet sein, beispielsweise durch einen Schlitz oder eine sonstige Öffnung, etwa um eine andere elektrische Verbindung innerhalb des Pixels durch die Öffnung hindurch zu ermöglichen.

Insbesondere kann die Abschirmstruktur eine C-Form oder eine U-Form aufweisen.

Bei einigen Ausführungsformen kann die Abschirmstruktur sich innerhalb einer Ebene erstrecken, insbesondere innerhalb einer Anordnungsebene, in welcher auch der Ausleseknoten liegt. Die Abschirmstruktur kann sich jedoch auch innerhalb einer Ebene erstrecken, die geringfügig oberhalb oder unterhalb der Anordnungsebene verläuft, in welcher der Ausleseknoten liegt.

Die Abschirmstruktur kann über eine Verbindungsleitung direkt oder indirekt mit dem Signalausgang des Wandler-Transistors verbunden oder koppelbar sein, wobei zumindest ein an die Abschirmstruktur angrenzender Teil der Verbindungsleitung im Wesentlichen senkrecht zu der Erstreckungsebene der Abschirmstruktur verläuft. Hierdurch kann eine kompakte und wirksame Anordnung der Abschirmstruktur erzielt werden.

Bei einigen Ausführungsformen kann die Abschirmstruktur durch eine Metallbahn gebildet sein. Auch die elektrische Verbindung der Abschirmstruktur mit der Ausgangsleitung des Pixels, die den Signalausgang des Wandler-Transistors des Pixels mit dem zugeordneten Auswahl-Schalter verbindet, kann durch eine Metallbahn gebildet sein. Derartige Metallbahnen können bei der Herstellung des Pixels durch eine jeweilige Metallisierung gebildet werden.

Bei einigen Ausführungsformen kann die Abschirmstruktur durch einen Kanal ("aktiv") gebildet sein, der insbesondere in der Ebene der Silizium-Oberfläche bzw. des verwendeten Halbleitersubstrats liegen kann und dauerhaft elektrisch leitend sein kann. Dieser Kanal kann insbesondere direkt mit dem Signalausgang (z.B. Source-Anschluss) des Wandler-Transistors verbunden sein.

Bei einigen Ausführungsformen kann das jeweilige Pixel eine weitere elektrisch leitende Abschirmstruktur aufweisen, die den Ausleseknoten ebenfalls zumindest teilweise umgibt und die auf ein elektrisches Potential gesetzt oder setzbar ist, das von dem Spannungssignal des Wandler-Transistors abhängt. Somit kann der Ausleseknoten des jeweiligen Pixels von einer ersten Abschirmstruktur teilweise umgeben sein und von einer zweiten Abschirmstruktur teilweise umgeben sein, insbesondere in einer zueinander komplementären Anordnung, wobei das elektrische Potential der ersten Abschirmstruktur und das elektrische Potential der zweiten Abschirmstruktur in unterschiedlicher Weise von dem Spannungssignal des Wandler-Transistors abhängen kann. Somit kann eine besonders robuste Abschirmung bzw. Verringerung der Kapazität des Ausleseknotens erzielt werden. Beispielsweise kann die erste Abschirmstruktur direkt mit dem Signalausgang des Wandler-Transistors verbunden sein, während die zweite Abschirmstruktur indirekt mit dem Signalausgang des Wandler-Transistors verbunden sein kann, beispielsweise über den erläuterten Impedanzwandler (insbesondere in der Konfiguration als Verstärker).

Die Abschirmstruktur kann in einer kompakten Pixelarchitektur ausgeführt sein, bei der die Verbindung zwischen der Abschirmstruktur und dem Signalausgang des Wandler-Transistors vollständig innerhalb des jeweiligen Pixels gebildet ist.

Bei einigen Ausführungsformen kann der Ausleseknoten einen Brückenabschnitt umfassen, der einen Ausgang des Transfer-Gate mit einem Gate-Anschluss des Wandler-Transistors verbindet, wobei das Transfer-Gate und der Wandler-Transistor in einer ersten Ebene des Pixels liegen (insbesondere Substrat- bzw. Dotierungsebene) und der Brückenabschnitt des Ausleseknotens in einer zweiten Ebene des Pixels liegt (insbesondere Metallisierungsebene), die relativ zu der ersten Ebene parallelversetzt ist, und wobei die Abschirmstruktur einen Abschirmabschnitt umfasst, der in der zweiten Ebene des Pixels liegt und den Brückenabschnitt des Ausleseknotens zumindest teilweise umgibt. Wenn bei einer derartigen Ausführungsform die Abschirmstruktur und somit der Abschirmungsabschnitt auf ein Potential gesetzt werden, das von dem Spannungssignal des Wandler-Transistors abhängt, können hierdurch bei einer dichten Anordnung der notwendigen Elemente des Pixels eine wirkungsvolle Abschirmung des Ausleseknotens und somit eine Verringerung der effektiven Kapazität des Ausleseknoten erzielt werden.

Bei derartigen Ausführungsformen mit einem abgeschirmten, vertikal versetzten Brückenabschnitt des Ausleseknotens kann der Brückenabschnitt über eine erste Durchkontaktierung, die senkrecht zu der ersten Ebene des Pixels verläuft, mit dem Ausgang des Transfer-Gate verbunden sein, wobei der Brückenabschnitt über eine zweite Durchkontaktierung, die senkrecht zu der ersten Ebene des Pixels verläuft, mit dem Gate-Anschluss des Wandler-Transistors verbunden sein kann.

Bei derartigen Ausführungsformen mit einem Brückenabschnitt des Ausleseknotens kann der Brückenabschnitt den Signalausgang des Wandler-Transistors überqueren, um die Abschirmwirkung noch weiter zu erhöhen.

Der Brückenabschnitt des Ausleseknotens kann durch eine Metallbahn auf einem Halbleitersubstrat gebildet sein, während das Transfer-Gate und der Wandler-Transistor des Pixels (insbesondere deren Durchlasskanäle, also die Source-Drain-Verbindungen) durch elektrisch leitende Kanäle in dem Halbleitersubstrat gebildet sein können.

Bei derartigen Ausführungsformen mit einem Brückenabschnitt des Ausleseknotens kann der Abschirmabschnitt einen umfänglich geschlossenen Ring bilden, der innerhalb der zweiten Ebene des Pixels den Brückenabschnitt seitlich umschließt.

Gemäß einem ersten Erfindungsaspekt überdeckt der in der zweiten Ebene des Pixels verlaufende Abschirmabschnitt der Abschirmstruktur den Ausgang des Transfer-Gate und den Signalausgang des Wandler-Transistors zumindest teilweise, um die Abschirmwirkung noch weiter zu erhöhen.

Der in der zweiten Ebene des Pixels verlaufende Abschirmabschnitt der Abschirmstruktur kann über eine Durchkontaktierung, die senkrecht zu der ersten Ebene des Pixels verläuft, mit dem Signalausgang des Wandler-Transistors elektrisch verbunden sein.

Gemäß einem zweiten Erfindungsaspekt umfasst die Abschirmstruktur zusätzlich zu dem in der zweiten Ebene des Pixels verlaufenden Abschirmabschnitt wenigstens einen weiteren Abschirmabschnitt, der in der ersten Ebene des Pixels verläuft und der benachbart zu dem Transfer-Gate und/oder zu dem Wandler-Transistor angeordnet ist. Auch hierdurch kann die Abschirmwirkung noch weiter zu erhöht werden.

Ein derartiger weiterer Abschirmabschnitt kann einen länglichen Finger bilden, der ein freies Ende aufweist.

Der weitere Abschirmabschnitt der Abschirmstruktur kann parallel zu einem Durchlasskanal des Wandler-Transistors verlaufen. Alternativ oder zusätzlich kann der weitere Abschirmabschnitt parallelversetzt und gleichgerichtet zu einem Teil des in der zweiten Ebene des Pixels liegenden Abschirmabschnitts verlaufen.

Bei einigen Ausführungsformen kann die Abschirmstruktur mehr als die Hälfte einer kürzesten Strecke umgeben, die von dem Ausgang des Transfer-Gate zu dem Eingang (Gate-Anschluss) des Wandler-Transistors verläuft.

Bei einigen Ausführungsformen kann der Wandler-Transistor dazu ausgebildet sein und derart mit dem Ausleseknoten gekoppelt sein, dass das an dem Signalausgang des Wandler-Transistors (z.B. Source-Anschluss) erzeugte Spannungssignal von der in dem Ausleseknoten vorhandenen Ladung abhängt.

Bei einigen Ausführungsformen kann der Bildsensor, wie bereits erwähnt, eine Steuereinrichtung umfassen, die zumindest mit dem Transfer-Gate und dem Auswahl-Schalter des jeweiligen Pixels verbunden ist und dazu ausgebildet ist, Steuersignale für das Transfer-Gate und den Auswahl-Schalter zu erzeugen.

Bei einigen Ausführungsformen kann das jeweilige Pixel ferner einen Rücksetz-Schalter umfassen, um wahlweise den Ausleseknoten mit einem Rücksetz-Potential zu koppeln. Die genannte Steuereinrichtung kann dazu ausgebildet sein, auch Steuersignale für den Rücksetz-Schalter zu erzeugen.

Bei einigen Ausführungsformen kann das jeweilige Pixel ferner einen Überlauf-Kondensator und ein weiteres Transfer-Gate umfassen, um wahlweise den Ausleseknoten mit dem Überlauf-Kondensator zu koppeln. Hierdurch kann die Kapazität des Ausleseknotens wahlweise temporär erhöht werden, um bei starker Belichtung große Ladungsmengen von dem lichtempfindlichen Element aufnehmen zu können. Die genannte Steuereinrichtung kann dazu ausgebildet sein, auch Steuersignale für das weitere Transfer-Gate zu erzeugen.

Bei einigen Ausführungsformen kann die zugeordnete Ausleseleitung mit einem Ausleseverstärker und/oder mit einem Signalbus, der zu einem Ausgangsverstärker führt, verbunden sein oder koppelbar sein.

Die Erfindung wird nachfolgend anhand von Ausführungsbeispielen mit Bezug auf die Zeichnungen beschrieben, wobei gleiche oder gleichartige Elemente mit denselben Bezugszeichen gekennzeichnet sind. Es zeigen:
- Fig. 1: einen Vier-Transistor-CMOS-Bildsensor gemäß dem Stand der Technik, wobei von dem Bildsensor lediglich ein Pixel und eine der Spaltenleitung des Pixels zugeordnete Spaltenausleseschaltung dargestellt sind;
- Fig. 2: einen erfindungsgemäßen Bildsensor in einer der Fig. 1 entsprechenden Darstellungsweise;
- Fig. 3: eine alternative Ausführungsform des jeweiligen Pixels eines Bildsensors gemäß Fig. 2;
- Fig. 4: eine weitere alternative Ausführungsform des jeweiligen Pixels eines Bildsensors gemäß Fig. 2 mit zusätzlichem Ersatzschaltbild der Kapazitäten;
- Fig. 5 bis 10: alternative Ausführungsformen eines Bildsensors gemäß Fig. 2;
- Fig. 11: eine Draufsicht auf eine erste Ebene eines Pixels eines Bildsensors; und
- Fig. 12: eine Draufsicht auf eine zweite Ebene des Pixels gemäß Fig. 11.

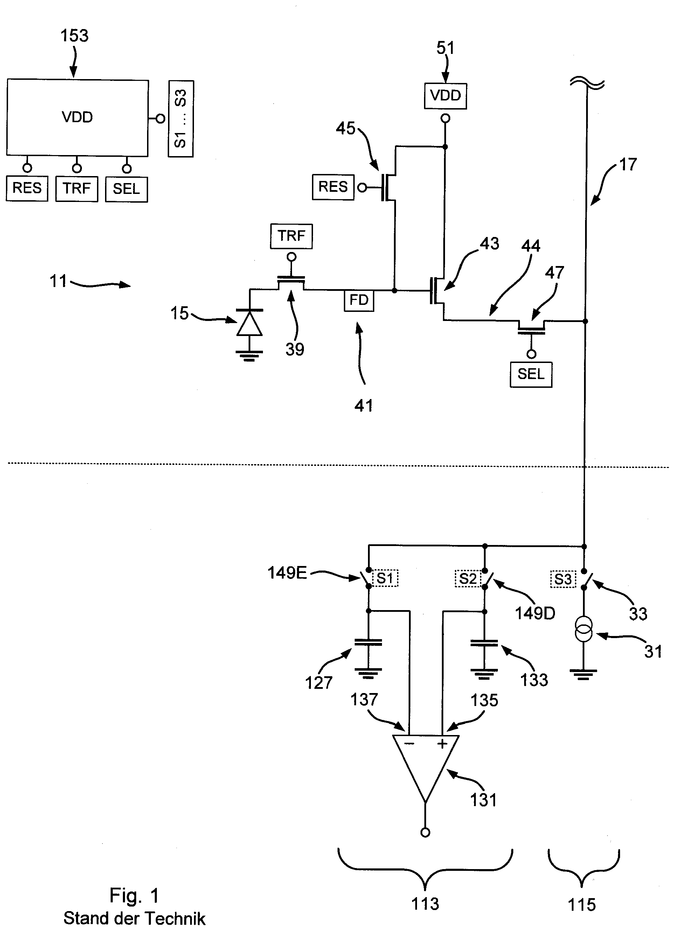

Die grundlegende Funktionsweise eines beispielhaften herkömmlichen Vier-Transistor-Bildsensors des APS-Typs (aktiver Pixelsensor) wird zum besseren Verständnis der Erfindung nachfolgend mit Bezug auf Fig. 1 erläutert, wobei einzelne Komponenten dieses Bildsensors auch bei einem erfindungsgemäßen Bildsensor vorhanden sind. Grundsätzlich ist die vorliegende Erfindung nicht auf aktive Vier-Transistor-Bildsensoren beschränkt, sondern kann auch bei Bildsensoren mit weniger oder mehr als vier Transistoren je Pixel zum Einsatz gelangen, wie nachfolgend noch erläutert wird.

In Fig. 1 ist stellvertretend lediglich ein einziges Pixel 11 dargestellt, welches ein einziges lichtempfindliches Element 15 in Form einer Photodiode umfasst, insbesondere einer sogenannten Pinned-Diode. Das lichtempfindliche Element 15 kann über einen Schalter in Form eines Transfer-Gates 39 wahlweise mit einem Ausleseknoten 41, der insbesondere als eine sogenannte Floating Diffusion (FD) ausgebildet ist, ladungsgekoppelt werden.

Der Ausleseknoten 41 ist mit dem Gate-Anschluss eines als Source-Folger ausgebildeten Wandler-Transistors 43 verbunden, der durch einen Feldeffekttransistor (FET) gebildet ist und eine Ladungs-Spannungs-Wandlerschaltung darstellt. Ferner ist der Ausleseknoten 41 über eine weitere Schalteinrichtung in Form eines Rücksetz-Schalters 45 mit einer (beispielsweise positiven) Spannungsversorgung 51 verbunden. Einer der beiden Kanalanschlüsse (Drain-Anschluss) des Wandler-Transistors 43 ist ebenfalls mit der positiven Spannungsversorgung 51 verbunden, wohingegen der andere der beiden Kanalanschlüsse (Source-Anschluss) des Wandler-Transistors 43 einen Signalausgang 44 bildet, an dem ein Spannungssignal ausgegeben wird und der über eine Ausgangsleitung mit einem Auswahl-Schalter 47 verbunden ist. Der Auswahl-Schalter 47 fungiert als Zeilenauswahlschalter, wobei durch Aktivieren bzw. Schließen des Auswahl-Schalters 47 der Signalausgang 44 des Wandler-Transistors 43 wahlweise mit einer dem dargestellten Pixel 11 zugeordneten Ausleseleitung in Form einer Spaltenleitung 17 gekoppelt werden kann.

Die Spaltenleitung 17 ist dafür vorgesehen, die in einer zugehörigen Spalte angeordneten gleichartigen Pixel 11 mit einer gemeinsamen Spaltenausleseschaltung 113, beispielsweise einer Spaltenverstärkerschaltung, zu verbinden. Dies geschieht alternierend durch temporäres Schließen des jeweiligen Auswahl-Schalters 47 der Pixel 11.

Die Spaltenausleseschaltung 113 umfasst einen ersten Kondensator oder Referenzwert-Kondensator 127, der mit einem Anschluss gegen Masse geschaltet und mit dem anderen Anschluss über einen Schalter 149E wahlweise mit der Spaltenleitung 17 koppelbar ist. Die Spaltenausleseschaltung 113 umfasst ferner einen zweiten Kondensator oder Signalwert-Kondensator 133, der mit einem Anschluss ebenfalls gegen Masse geschaltet und mit dem anderen Anschluss über einen weiteren Schalter 149D ebenfalls wahlweise mit der Spaltenleitung 17 koppelbar ist. Ferner umfasst die Spaltenausleseschaltung 113 einen Verstärker 131, an dessen negativem Eingang 137 die an dem ersten Kondensator 127 anliegende Spannung und an dessen positivem Eingang 135 die an dem zweiten Kondensator 133 anliegende Spannung angelegt wird.

Das Transfer-Gate 39 des jeweiligen Pixels 11 ist über eine Steuerleitung TRF, der Rücksetz-Schalter 45 ist über eine Steuerleitung RES, der Auswahl-Schalter 47 ist über eine Steuerleitung SEL, der Schalter 149E ist über eine Steuerleitung S1, und der Schalter 149D ist über eine Steuerleitung S2 von einer gemeinsamen Steuereinrichtung 153 des Bildsensors steuerbar.

Der Spaltenleitung 17 ist ferner außerhalb des Pixelfelds des Bildsensors (unterer Teil von Fig. 1) eine Vorladeschaltung 115 zugeordnet, welche eine Stromquelle 31 umfasst, die mittels eines Trennschalters 33 mit der Spaltenleitung 17 wahlweise koppelbar ist. Die Ansteuerung des Trennschalters 33 erfolgt durch die gemeinsame Steuereinrichtung 153 über eine Steuerleitung S3.

Nachfolgend wird das Funktionsprinzip eines derartigen Pixels 11 exemplarisch, basierend auf einer 3,3 V-CMOS-Technologie, beschrieben. Dieses Verfahren wird auch als "Correlated Double Sampling" (CDS) bezeichnet. Typischerweise können alle Pixel 11 in einer Zeile auf die gleiche Weise und insbesondere parallel ausgelesen werden, so dass es für die Beschreibung des Auslesevorgangs ausreicht, nur diejenigen Pixel 11 zu betrachten, die mit derselben Spaltenleitung 17 verbunden sind.

Zunächst wird das während eines Belichtungsvorgangs einfallende Licht von dem lichtempfindlichen Element 15 in elektrische Ladung umgewandelt, sodass sich das lichtempfindliche Element 15 mit Elektronen füllt. Während des Belichtungsvorgangs werden die Steuerleitungen TRF, RES und SEL jeweils auf 0 V gehalten, d.h. die hierdurch angesteuerten Schalter 39, 45, 47 sind geöffnet.

Vor dem eigentlichen Auslesen wird in einem Vorlade-Schritt (Pre-Charge) der Trennschalter 33 zunächst geschlossen und sodann, nachdem die Spaltenleitung 17 auf ein definiertes Referenzpotential (hier: Massepotential) gesetzt worden ist, wieder geöffnet. Parallel hierzu wird an die Steuerleitung RES kurzzeitig eine Spannung von 3,3 V angelegt, um durch Leckströme und/oder Streulicht gebildete Ladung aus dem Ausleseknoten 41 zu entfernen, d.h. um den Ausleseknoten 41 zu löschen. Der Ausleseknoten 41 wird also auf einen durch die Spannungsversorgung 51 definierten Referenzwert gesetzt. An dem Signalausgang 44 des Wandler-Transistors 43 stellt sich somit eine Spannung ein, die der Ladung an dem gelöschten Ausleseknoten 41 entspricht.

In einem nächsten Schritt (Lesen eines Referenzwerts) wird an die Steuerleitung SEL eine Spannung von 3,3 V angelegt, sodass der Auswahl-Schalter 47 geschlossen wird. Zusätzlich wird der Schalter 149E geschlossen. Hierdurch wird der der Ladung im Ausleseknoten 41 entsprechende Spannungswert des Wandler-Transistors 43 über den Auswahl-Schalter 47 auf die Spaltenleitung 17 geschaltet und somit zum Kondensator 127 übertragen. Nachdem das System eingeschwungen ist, wird der Auswahl-Schalter 47 durch ein entsprechendes Steuersignal wieder geöffnet und gleichzeitig wird der Kondensator 127 durch Öffnen des Schalters 149E wieder von der Spaltenleitung 17 getrennt.

Anschließend wird in einem weiteren Vorlade-Schritt durch kurzzeitiges Schließen des Trennschalters 33 die Spaltenleitung 17 erneut auf das definierte Referenzpotential vorgeladen. Parallel hierzu wird an die Steuerleitung TRF kurzzeitig eine Spannung von 3,3 V angelegt, um das Transfer-Gate 39 kurzzeitig zu öffnen bzw. den hierdurch gebildeten Schalter zu schließen, sodass die belichtungsabhängig erzeugten Elektronen von dem lichtempfindlichen Element 15 zu dem Ausleseknoten 41 fließen können (Transfer-Schritt).

In einem nächsten Schritt (Lesen eines Signalwerts) werden der Auswahl-Schalter 47 und der Schalter 149D geschlossen. Hierdurch wird der der Ladung im Ausleseknoten 41 entsprechende Spannungswert des Wandler-Transistors 43 über den Auswahl-Schalter 47 auf die Spaltenleitung 17 geschaltet und somit zum Kondensator 133 übertragen. Nachdem das System eingeschwungen ist, wird der Kondensator 133 durch Öffnen des Schalters 149D wieder von der Spaltenleitung 17 getrennt. Durch Anlegen von 0 V an die Steuerleitung SEL wird auch der Auswahl-Schalter 47 geöffnet und das Pixel 11 von der Spaltenleitung 17 getrennt.

Am Ausgang des Verstärkers 131 liegt nun eine Spannung an, die der Differenz der in den Kondensatoren 127, 133 gespeicherten Spannungswerte und damit der in dem lichtempfindlichen Element 15 erzeugten Ladungsmenge entspricht.

Schließlich kann in noch einem weiteren Schritt eine Spannung von 3,3 V kurzzeitig an die Steuerleitungen RES und TRF angelegt werden, um die Ladung aus dem Ausleseknoten 41 und eventuelle Restladung aus dem lichtempfindlichen Element 15 zu entfernen, damit der nächste Belichtungsvorgang wieder mit einem völlig "leeren" Pixel 11 beginnen kann.

Diese Schritte werden auch für die weiteren, mit der jeweiligen Spaltenleitung 17 verbundenen Pixel 11 durchgeführt.

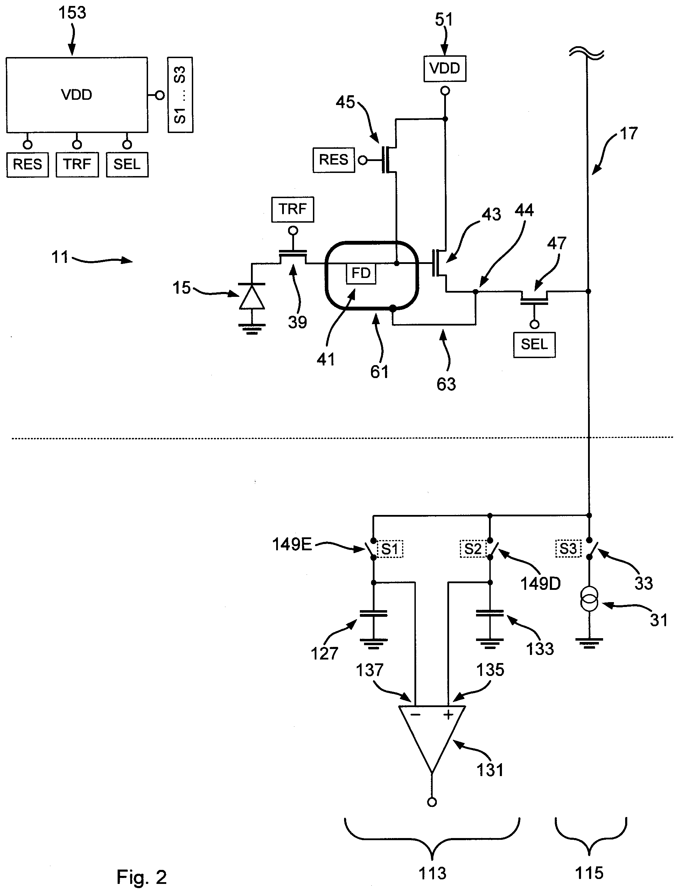

Fig. 2 zeigt Teile eines erfindungsgemäßen Bildsensors, wobei erneut beispielhaft ein Vier-Transistor-Bildsensor illustriert ist und stellvertretend lediglich ein einziges Pixel 11 dargestellt ist, obgleich der Bildsensor eine Vielzahl von in Zeilen und Spalten angeordneten Pixeln 11 aufweist.

Ein wesentlicher Unterschied zu Fig. 1 besteht darin, das jeweilige Pixel 11 eine elektrisch leitende Abschirmstruktur 61 aufweist, die den Ausleseknoten 41 umgibt, wobei die Abschirmstruktur 61 auf ein elektrisches Potential gesetzt ist, das von dem Spannungssignal des Wandler-Transistors 43 abhängt. Hierfür ist die die Abschirmstruktur 61 bei der in Fig. 2 gezeigten Ausführungsform des Pixels 11 über eine elektrisch leitende Verbindungsleitung 63 mit dem Signalausgang 44 des Wandler-Transistors 43 bzw. mit einer Ausgangsleitung verbunden, welche den Signalausgang 44 des Wandler-Transistors 43 mit dem Auswahl-Schalter 47 verbindet.

Die Abschirmstruktur 61 ist somit an mehreren Seiten des Ausleseknotens 41 benachbart zu dem Ausleseknoten 41 angeordnet, insbesondere auch benachbart zu der Verbindung von dem Ausleseknoten 41 zu dem Eingang des Wandler-Transistors 43. Die Abschirmstruktur 61 liegt nicht auf festem Potential. Da die Abschirmstruktur 61 mit dem Signalausgang 44 des Wandler-Transistors 43 bzw. des Pixels 11 verbunden ist, folgt das an der Abschirmstruktur 61 anliegende elektrische Potential vielmehr dem Potential bzw. dem Spannungssignal am Signalausgang 44 des Wandler-Transistors 43, welches wiederum von der im Ausleseknoten 41 angesammelten Ladung abhängt.

Hierdurch verringert sich die Potentialdifferenz des Kondensators, der durch die parasitäre Kapazität des Ausleseknotens 41 und die Kapazität der Abschirmstruktur 61 in der Umgebung des Ausleseknotens 41 gebildet ist. Folglich verringert sich auch die wirksame Kapazität des Ausleseknotens 41. Die Signal-Spannung, die im Ausleseknoten 41 durch ein von dem lichtempfindlichen Element 15 erzeugtes Elektron verursacht wird, erhöht sich entsprechend (ΔU = ΔQ / C). Dementsprechend verbessert sich das Verhältnis zwischen der Signal-Spannung, die ein Elektron verursacht, und der Rauschspannung des Wandler-Transistors 43. Das Rauschen des Pixels 11 ist hierdurch verringert, und die Lichtempfindlichkeit ist erhöht.

Wie in Fig. 2 gezeigt, kann die Abschirmstruktur 61 umfänglich geschlossen sein, insbesondere ringförmig. Die Abschirmstruktur 61 kann im Wesentlichen eine O-Form aufweisen oder beispielsweise mehreckig ausgebildet sein.

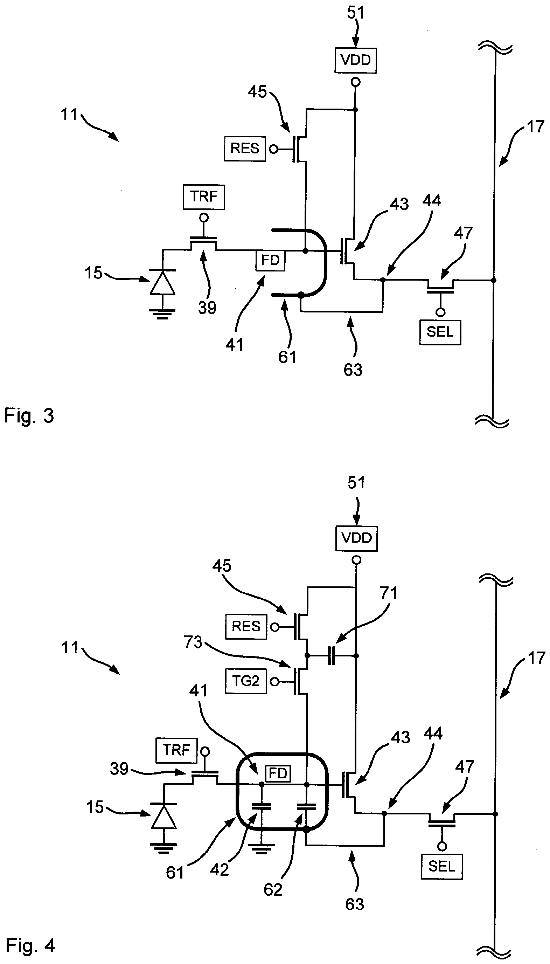

Fig. 3 zeigt eine alternative Ausführungsform, bei der die Abschirmstruktur 61 umfänglich geöffnet ist und den Ausleseknoten 41 an lediglich drei Seiten umgibt. Die Abschirmstruktur 61 ist im Wesentlichen U-förmig und in der Umgebung der Verbindung von dem Ausleseknoten 41 zu dem Eingang des Wandler-Transistors 43 angeordnet. Die Abschirmstruktur 61 könnte allerdings beispielsweise auch im Wesentlichen C-förmig sein. Die gezeigte U-Form oder die genannte C-Form könnte auch andersartig ausgerichtet sein, beispielsweise indem die geöffnete Seite der Abschirmstruktur 61 in Richtung des Wandler-Transistors 43 oder in Richtung des Rücksetz-Schalters 45 weist.

Bei den Ausführungsbeispielen gemäß Fig. 2 und 3 kann die Abschirmstruktur 61 sich innerhalb einer Erstreckungsebene erstrecken, welche der Darstellungsebene der Fig. 2 und 3 entspricht oder parallel zu der Darstellungsebene der Fig. 2 und 3 verläuft. Diese Erstreckungsebene der Abschirmstruktur 61 kann einer Anordnungsebene entsprechen, in welcher auch der Ausleseknoten 41 ausgebildet ist. Alternativ hierzu kann die Erstreckungsebene der Abschirmstruktur 61 auch geringfügig oberhalb oder unterhalb der Anordnungsebene verlaufen, in welcher der Ausleseknoten 41 liegt.

In sämtlichen der genannten Fälle kann die Verbindungsleitung 63 oder zumindest ein an die Abschirmstruktur 61 angrenzender Teil der Verbindungsleitung 63 (abweichend von der schematischen Darstellung gemäß Fig. 2 und 3) im Wesentlichen senkrecht zu der Erstreckungsebene der Abschirmstruktur 61 bzw. senkrecht zu der Darstellungsebene der Fig. 2 und 3 verlaufen, so dass die Verbindungsleitung 63 kurz gehalten und gut in die vorhandene Struktur des Pixels 11 integriert werden kann.

Die Abschirmstruktur 61 und die Verbindungsleitung 63 können durch Metallisierungen oder dauerhaft leitende Kanäle des verwendeten Substrats auf einfache Weise hergestellt werden. Die Ausbildung der Abschirmstruktur 61 und der Verbindungsleitung 63 kann somit auf einfache Weise in übliche Fertigungsprozesse eines Pixels 11 integriert werden.

Fig. 4 illustriert, dass die Abschirmstruktur 61 beispielsweise auch bei einem Fünf-Transistor-Bildsensor vorgesehen sein kann. Das jeweilige Pixel 11 gemäß Fig. 4 umfasst zusätzlich einen Überlauf-Kondensator 71 und ein weiteres Transfer-Gate 73. Das weitere Transfer-Gate 73 kann von der Steuereinrichtung 153 (vgl. Fig. 2) über eine Steuerleitung TG2 wahlweise dazu angesteuert werden, den Ausleseknoten 41 mit dem Überlauf-Kondensator 71 zu koppeln. Hierdurch kann die Kapazität des Ausleseknotens 41 wahlweise temporär erhöht werden, um bei hoher Belichtung des Pixels 11 große Ladungsmengen, die in dem lichtempfindlichen Element 15 erzeugt werden, aufnehmen zu können. Die hiermit verbundene (temporäre) Erhöhung der Kapazität des Ausleseknotens 41 wirkt sich insofern nicht nachteilig auf die Lichtempfindlichkeit aus, als bei hoher Belichtung ohnehin ein hohes Signal/Rausch-Verhältnis erzielt wird.

Fig. 4 illustriert ferner die bereits genannte (parasitäre) Kapazität des Ausleseknotens 41, die im Ersatzschaltbild als Kondensator 42 dargestellt ist, sowie die Kapazität der Abschirmstruktur 61, die als Kondensator 62 dargestellt ist. Die insgesamt wirksame Kapazität des Ausleseknotens 41 wird durch den Einfluss der Abschirmstruktur 61 verringert, da der Fußpunkt des gebildeten Kondensators entsprechend der Ladung im Ausleseknoten 41 und dem hieraus resultierenden Spannungssignal am Signalausgang 44 des Wandler-Transistors 43 angehoben wird.

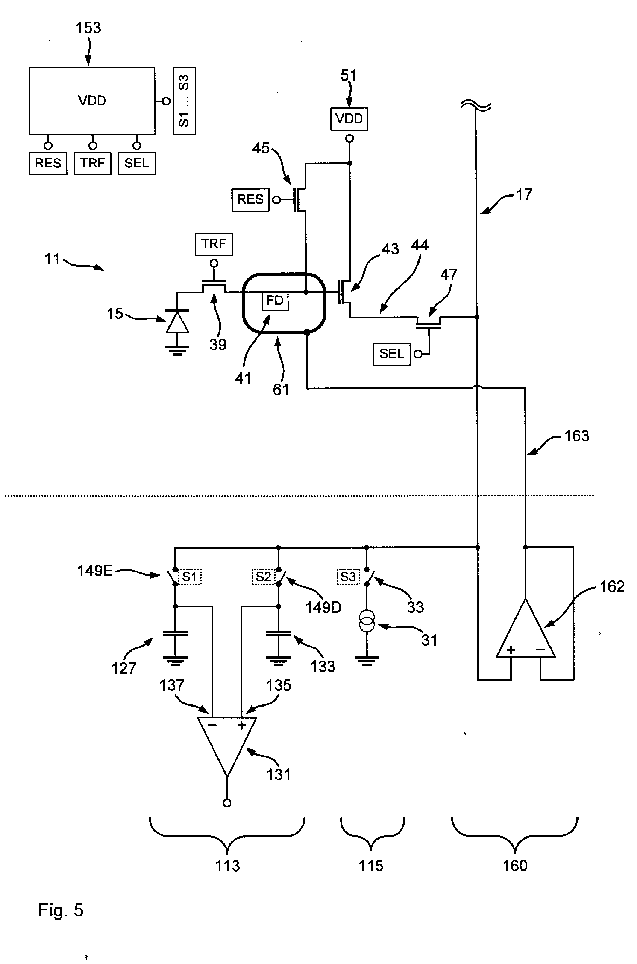

Fig. 5 bis 10 zeigen alternative Ausführungsformen eines Bildsensors mit Pixeln 11 in einer der Fig. 2 entsprechenden Darstellungsweise.

Bei der Ausführungsform gemäß Fig. 5 ist die Abschirmstruktur 61 lediglich indirekt mit dem Signalausgang 44 des Wandler-Transistors 43 verbunden, nämlich über die zugeordnete Ausleseleitung bzw. Spaltenleitung 17 und einen Impedanzwandler 162. Hierfür ist die Spaltenleitung 17 mit einem positiven Eingang des Impedanzwandlers 162 verbunden. Da dieser Eingang hochohmig ist, werden die über die Spaltenleitung 17 geführten Ausgangssignale der zugeordneten Wandler-Transistoren 43 der Pixel 11 der betreffenden Spalte nicht beeinträchtigt. Der Ausgang des Impedanzwandlers 162 ist über eine Verbindungsleitung 163 mit der Abschirmstruktur 61 des jeweiligen Pixels 11 verbunden. Somit ist für mehrere Pixel 11 ein gemeinsamer Impedanzwandler 162 vorgesehen (insbesondere außerhalb des Pixelfelds des Bildsensors), wobei über den Auswahl-Schalter 47 des jeweiligen Pixels 11 wahlweise eine Kopplung zwischen dem Signalausgang 44 des Wandler-Transistors 43 und der Abschirmstruktur 61 des jeweiligen Pixels 11 hergestellt werden kann.

Durch den Impedanzwandler 162 kann bei einer derartigen Anordnung verhindert werden, dass die Kapazität der Ausleseleitung bzw. Spaltenleitung 17 durch die jeweilige Abschirmstruktur 61 der zugeordneten Pixel 11 unerwünscht erhöht wird und die über die Spaltenleitung 17 weitergeleiteten Spannungssignale der Wandler-Transistoren 43 beeinträchtigt werden. Der Impedanzwandler 162 bildet somit eine Entkopplungsschaltung 160.

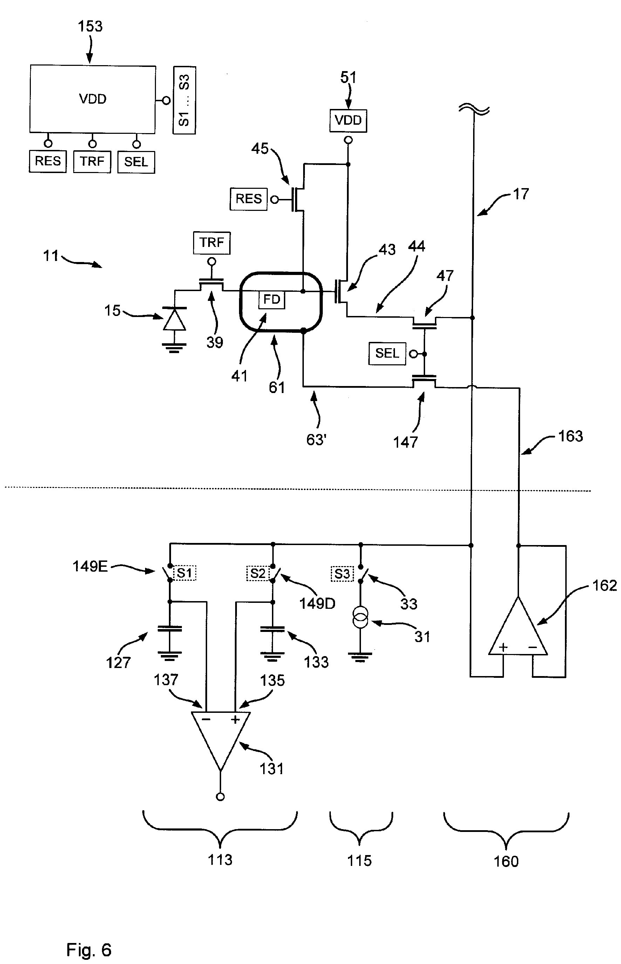

Bei der Ausführungsform gemäß Fig. 6 ist gegenüber Fig. 5 in der Verbindungsleitung 163 zwischen dem Ausgang des Impedanzwandlers 162 und der Abschirmstruktur 61 des jeweiligen Pixels 11 zusätzlich ein jeweiliger Koppel-Schalter 147 vorgesehen. Die Abschirmstruktur 61 ist über den Koppel-Schalter 147 wahlweise (indirekt, nämlich über den Impedanzwandler 162) mit dem Signalausgang 44 des Wandler-Transistors 43 koppelbar bzw. entkoppelbar. Hierdurch ist es möglich, den Ausgang des Impedanzwandlers 162 wahlweise lediglich zu bestimmten Zeiten mit einer jeweiligen Abschirmstruktur 61 zu koppeln. Somit kann beispielsweise verhindert werden, dass das elektrische Potential der jeweiligen Abschirmstruktur 61 durch hiermit verbundene Abschirmstrukturen 61 anderer Pixel 11 verfälscht wird.

Der Koppel-Schalter 147 trennt die Verbindungsleitung zwischen dem Ausgang des Impedanzwandlers 162 und der Abschirmstruktur 61 des jeweiligen Pixels 11 in einen ersten Abschnitt 163 und einen zweiten Abschnitt 63'.

Bei der in Fig. 6 gezeigten Ausführungsform ist der Koppel-Schalter 147 gemeinsam mit dem Auswahl-Schalter 47 des jeweiligen Pixels 11 ansteuerbar. Dies kann auf besonders einfache Weise durch eine gemeinsame Steuerleitung SEL geschehen. Somit ist gewährleistet, dass die jeweilige Abschirmstruktur 61 lediglich dann mit dem Ausgang des Impedanzwandlers 162 verbunden und auf ein dem Spannungssignal des Wandler-Transistors 43 entsprechendes elektrisches Potential gesetzt wird, wenn tatsächlich ein Spannungssignal des jeweiligen Pixels 11 ausgelesen werden soll.

Sofern für die Abschirmstruktur 61 des jeweiligen Pixels 11 ein Koppel-Schalter 147 vorgesehen ist (wie in Fig. 6 gezeigt gemeinsam mit dem Auswahl-Schalter 47 des jeweiligen Pixels 11 ansteuerbar, oder unabhängig ansteuerbar), so könnte grundsätzlich auch auf die Entkopplungsschaltung 160 bzw. den Impedanzwandler 162 verzichtet werden, d.h. die die Abschirmstruktur 61 des jeweiligen Pixels 11 könnte über den Koppel-Schalter 147, die zugeordnete Ausleseleitung bzw. Spaltenleitung 17, und den Auswahl-Schalter 47 des jeweiligen Pixels 11 mit dem Signalausgang 44 des Wandler-Transistors 43 koppelbar sein.

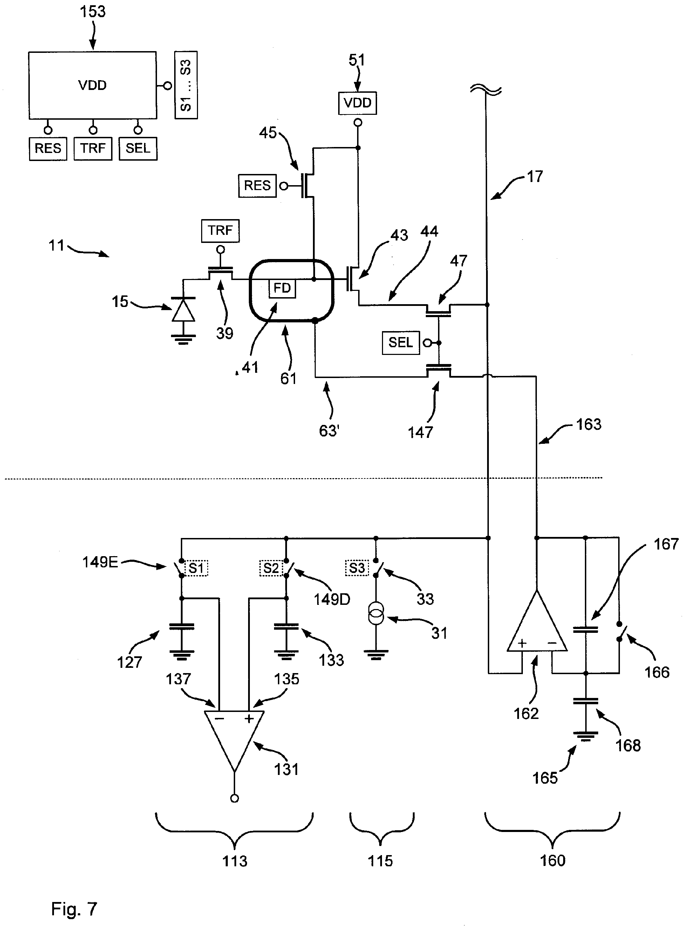

Die Ausführungsform gemäß Fig. 7 unterscheidet sich von der Ausführungsform gemäß Fig. 6 darin, dass der Impedanzwandler 162 als ein Verstärker konfiguriert ist. Beispielhaft sind in der Rückkoppelschleife zwei Kondensatoren 167, 168 gezeigt, um den Verstärkungsfaktor einzustellen, wobei alternativ beispielsweise auch ein Spannungsteiler gegen das Massepotential 165 durch Verwendung ohmscher Widerstände denkbar ist. Mittels eines Schalters 166 ist der Rückkoppel-Kondensator 167 überbrückbar, um die Verstärkung zu deaktivieren.

Durch Konfigurieren des Impedanzwandlers 162 als Verstärker kann die Abhängigkeit des elektrischen Potentials der Abschirmstruktur 61 von dem Spannungssignal des Wandler-Transistors 43 bzw. von der Ladungsmenge im Ausleseknoten 41 erhöht werden. Der Impedanzwandler 162 kann insbesondere dazu ausgebildet sein, das Spannungssignal des jeweiligen Wandler-Transistors 43 mit einer abnehmenden Verstärkungskennlinie zu verstärken.

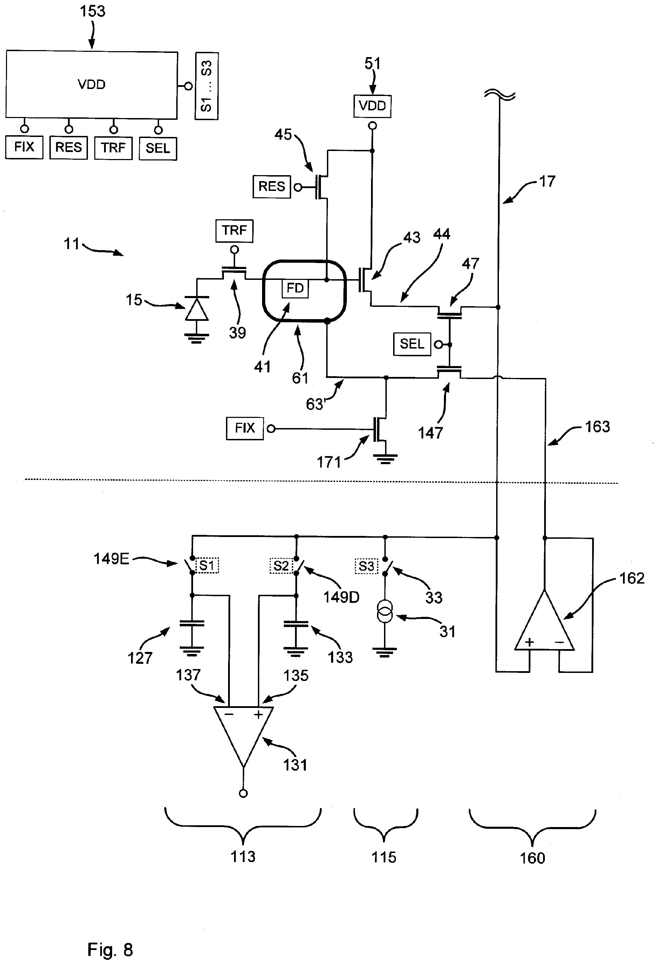

Die Ausführungsform gemäß Fig. 8 unterscheidet sich von der Ausführungsform gemäß Fig. 6 darin, dass die Abschirmstruktur 61 des jeweiligen Pixels 11 über einen weiteren Koppel-Schalter 171 mit einem elektrischen Bezugspotential koppelbar ist, insbesondere mit dem Massepotential. Hierdurch kann erreicht werden, dass die Abschirmstruktur 61, wenn der weitere Koppel-Schalter 171 geschlossen ist, auf einem definierten festen Potential liegt, um unerwünschte Beeinflussungen des Pixels 11 und insbesondere des Ausleseknotens 41 durch ein undefiniertes elektrisches Potential zu vermeiden.

Der weitere Koppel-Schalter 171 kann von der Steuereinrichtung 153 des Bildsensors über eine Steuerleitung FIX angesteuert werden. Die Steuereinrichtung 153 kann dazu ausgebildet sein, zu einem gegebenen Zeitpunkt lediglich den Auswahl-Schalter 47 zu schließen (für ein Auslesen des Pixels 11) oder lediglich den weiteren Koppel-Schalter 171 zu schließen (um das elektrische Potential der Abschirmstruktur 61 konstant zu halten).

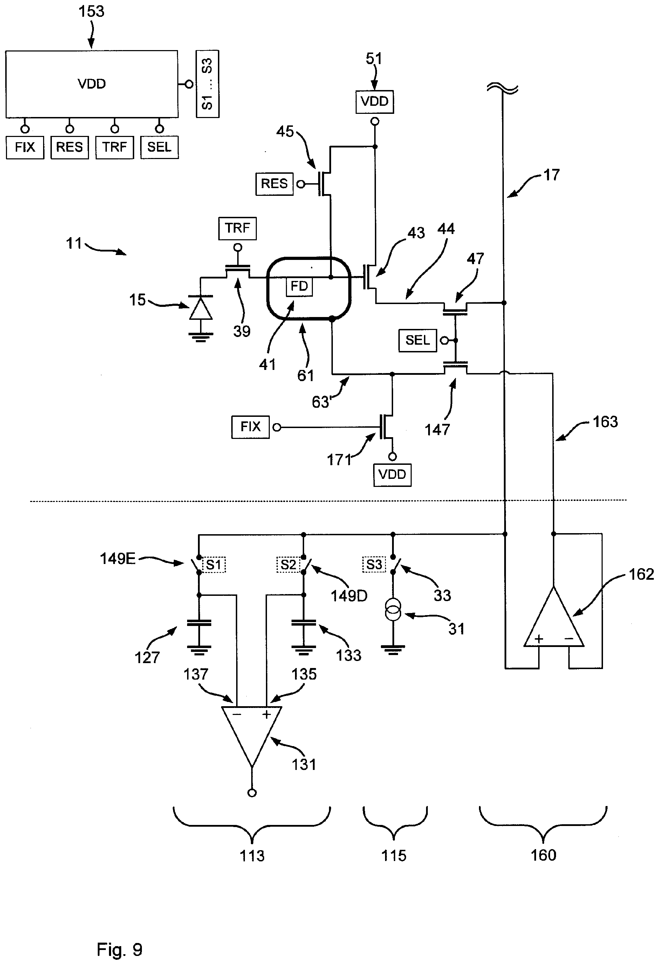

Die Ausführungsform gemäß Fig. 9 entspricht der Ausführungsform gemäß Fig. 8, wobei die Abschirmstruktur 61 des jeweiligen Pixels 11 über den weiteren Koppel-Schalter 171 mit der Versorgungsspannung VDD des Bildsensors gekoppelt werden kann.

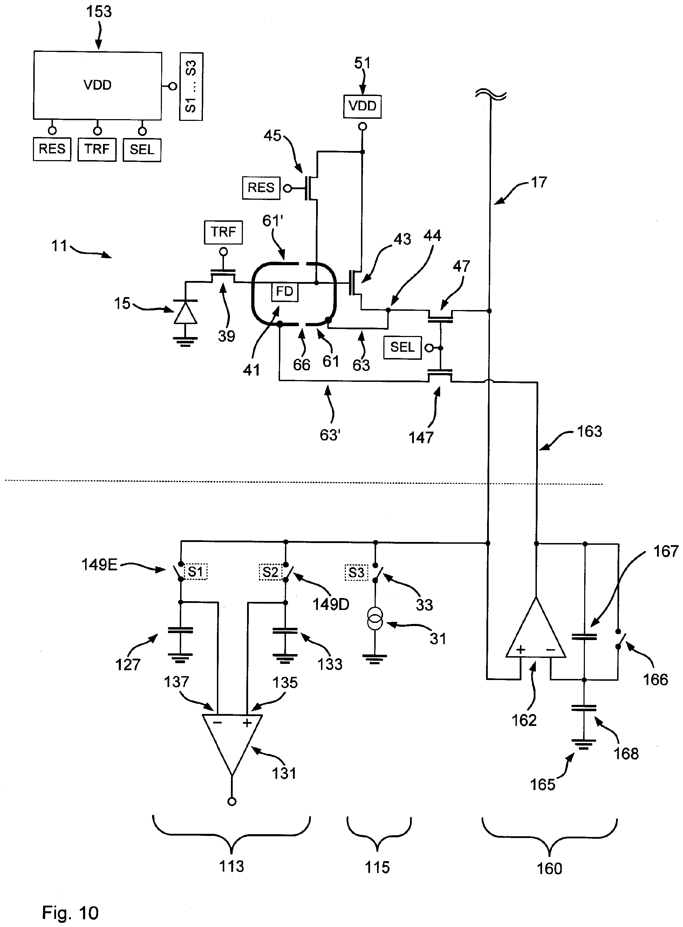

Fig. 10 illustriert, dass das jeweilige Pixel 11 zusätzlich zu der Abschirmstruktur 61 eine weitere Abschirmstruktur 61' aufweisen kann, wobei beide Abschirmstrukturen 61, 61' den Ausleseknoten 41 teilweise umgeben. Die beide Abschirmstrukturen 61, 61' können beispielsweise U-förmig sein, mit einander zugewandten offenen Seiten, um im Wesentlichen die Form eines geschlitzten Rings mit Isolierabstand 66 zu bilden.

Beide Abschirmstrukturen 61, 61' können auf einem elektrischen Potential liegen, das von dem Spannungssignal am Signalausgang 44 des Wandler-Transistors 43 abhängt, jedoch in unterschiedlicher Weise. Die eine Abschirmstruktur 61 kann hierfür wie bei der Ausführungsform gemäß Fig. 2 über eine Verbindungsleitung 63 direkt mit dem Signalausgang 44 des Wandler-Transistors 43 des jeweiligen Pixels 11 verbunden sein. Die andere Abschirmstruktur 61' kann wie bei der Ausführungsform gemäß Fig. 7 über einen Koppel-Schalter 147 mit dem Ausgang eines Impedanzwandlers 162 koppelbar sein, der Bestandteil einer Entkopplungsschaltung 160 ist und dessen Eingang über die Ausleseleitung bzw. Spaltenleitung 17 und den jeweiligen Auswahl-Schalter 47 mit dem Signalausgang 44 des Wandler-Transistors 43 koppelbar ist.

Die im Zusammenhang mit den Fig. 2 bis 10 erläuterten Ausführungsformen können auch in anderer Weise kombiniert werden.

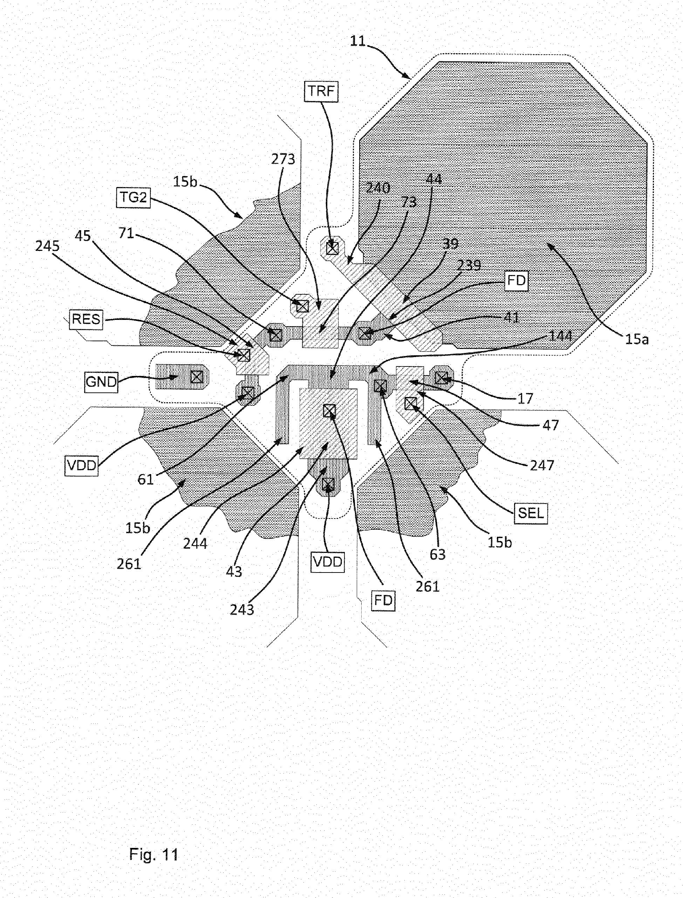

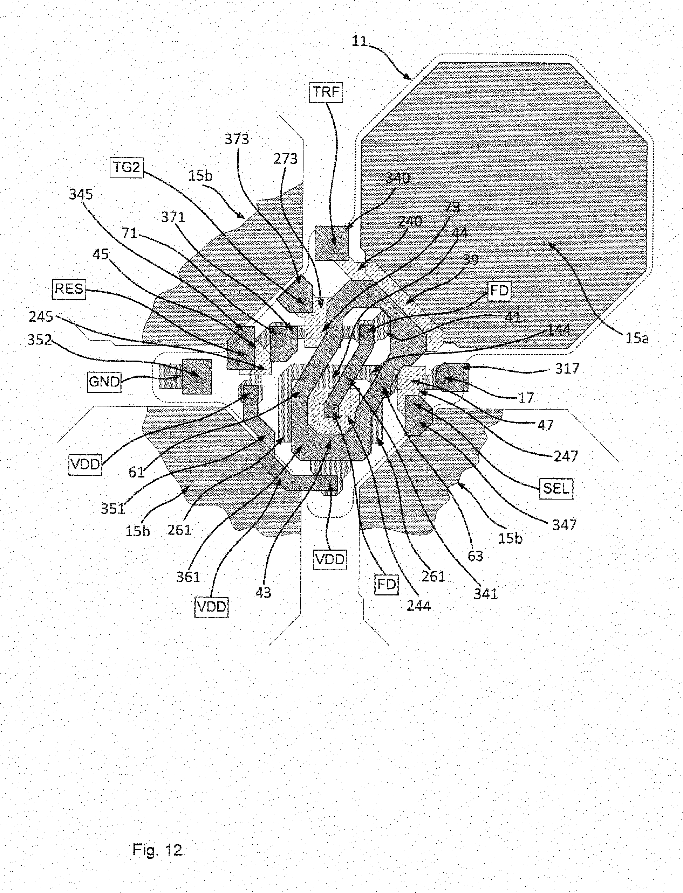

Eine vorteilhafte Ausführungsform eines Pixels 11 mit einer Abschirmstruktur 61 in einer kompakten Architektur wird nachfolgend anhand der Fig. 11 und 12 erläutert.

Fig. 11 zeigt in einer Draufsicht Komponenten eines Pixels 11, die in einer ersten, unteren Ebene angeordnet sind, wobei das lichtempfindliche Element 15a des Pixels 11 gezeigt ist und auch Teile der lichtempfindlichen Elemente 15b benachbarter Pixel zu erkennen sind. Es handelt sich hier um einen rückwärtig belichteten Bildsensor (back side illuminated, BSI), d.h. die Belichtung erfolgt von unten, entgegen der Betrachtungsrichtung. Die lichtempfindlichen Elemente 15a, 15b sind achteckig und sind mit jeweils insgesamt vier Kanten benachbart zueinander angeordnet. Hierdurch wird innerhalb der gezeigten Ebene ein hoher Füllfaktor erreicht.

Zwischen den verbleibenden vier (schrägen) Kanten sind die weiteren Komponenten des jeweiligen Pixels 11 angeordnet. Zu erkennen ist das Transfer-Gate 39, und zwar mit einem Durchlasskanal 239, der von einem Gate-Anschluss 240 überdeckt ist (hell schraffiert dargestellt), welcher mit einem Anschluss für die Steuerleitung TRF verbunden ist. Zu erkennen ist ferner ein Teil des Ausleseknotens 41 (Floating Diffusion, FD). Zu erkennen ist ferner der Wandler-Transistor 43. Der Wandler-Transistor 43 umfasst einen Drain-Anschluss, der bei VDD mit der Versorgungsspannung 51 verbunden ist; ferner einen Durchlasskanal 243; und einen Source-Anschluss, der den Signalausgang 44 bildet. Ein Gate-Anschluss 244 des Wandler-Transistors 43 ist hell schraffiert dargestellt. Derartige "Anschlüsse" des Pixels 11 sind generell als funktionale Elemente zu verstehen und können durch entsprechende Bereiche des Pixels 11 (z.B. innerhalb des Halbleitersubstrats) und/oder durch abgegrenzte Strukturen des Pixels 11 gebildet sein.

Der Ausleseknoten 41 (Floating Diffusion, FD) reicht bis an die Oberseite des Gate-Anschlusses 244 des Wandler-Transistors 43, wie nachfolgend noch erläutert wird. Der Signalausgang 44 des Wandler-Transistors 43 ist über eine Ausgangsleitung 144 mit dem Auswahl-Schalter 47 verbunden. Der Signalausgang 44 des Wandler-Transistors 43 kann somit über den Auswahl-Schalter 47 wahlweise mit einem Anschluss für die Spaltenleitung 17 verbunden werden. Hierfür umfasst ein Gate-Anschluss 247 (hell schraffiert dargestellt) des Auswahl-Schalters 47 einen Anschluss für die Steuerleitung SEL. Zu erkennen ist ferner der Rücksetz-Schalter 45, der einen Anschluss VDD für die Versorgungsspannung 51 wahlweise mit dem Ausleseknoten 41 verbindet (hier indirekt über das nachfolgend genannte weitere Transfer-Gate 73). Der Rücksetz-Schalter 45 umfasst einen Gate-Anschluss 245 (hell schraffiert dargestellt), der mit der Steuerleitung RES verbunden ist. Zu erkennen ist ferner ein Anschluss für eine Masseleitung GND.

Optional kann das Pixel 11, wie im Zusammenhang mit Fig. 4 erläutert, einen Überlauf-Kondensator 71 aufweisen (in Fig. 11 und 12 nicht dargestellt), der über ein weiteres Transfer-Gate 73 wahlweise mit dem Ausleseknoten 41 verbunden werden kann, wobei das weitere Transfer-Gate 73 einen Gate-Anschluss 273 (hell schraffiert dargestellt) aufweist, der einen Anschluss für die Steuerleitung TG2 aufweist.

Die in Fig. 11 gezeigten und vorstehend aufgezählten Komponenten des Pixels 11 sind im Wesentlichen innerhalb einer gemeinsamen Ebene angeordnet. Die gezeigten elektrischen Verbindungen, insbesondere der Durchlasskanal 239 des Transfer-Gate 39 und der Durchlasskanal 243 des Wandler-Transistors, können durch eine Dotierung des verwendeten Halbleitersubstrats (z.B. Silizium) gebildet sein (beispielsweise durch Diffusion oder Implantation erzeugt). Die genannten Gate-Anschlüsse 240, 244, 245, 247 und 273 können Aluminium oder dotiertes Polysilizium umfassen. Die Gate-Anschlüsse 240, 244, 245, 247 und 273 sind bezüglich der dotierten Bereiche des Halbleitersubstrats relativ dünn und sind deshalb noch der ersten (unteren) Anordnungsebene gemäß Fig. 11 zuzuordnen.

Fig. 12 zeigt in einer der Fig. 11 entsprechenden Draufsicht zusätzliche Elemente des Pixels 11, die als Metallisierungen in einer zweiten Ebene angeordnet sind. Diese zweite Ebene verläuft oberhalb der ersten Ebene gemäß Fig. 11 und in vertikaler Richtung parallelversetzt zu dieser. Die unter den Metallisierungen vorhandenen Elemente der ersten Ebene gemäß Fig. 11 sind weiterhin ersichtlich. Die Metallisierungen (z.B. Aluminium oder Aluminiumlegierung) können beispielsweise durch Aufdampfen oder Sputtern und anschließendes Freistellen durch Ätzen erzeugt sein. Die Metallisierungen gemäß Fig. 12 können in vertikaler Richtung von der ersten Ebene gemäß Fig. 11 durch einen elektrischen Isolator bzw. Dielektrikum (z.B. Siliziumdioxid) getrennt sein. Das Halbleitersubstrat, der elektrische Isolator und die Metallisierungen können eine Folge von stoffschlüssig übereinander liegenden Schichten bilden.

Die in Fig. 12 gezeigten Metallisierungen (dunkel schraffiert dargestellt) bilden elektrische Kontakte, Verbindungen und Kondensatoren. Zu erkennen sind ein Kontaktbereich 340 für den Gate-Anschluss 240 des Transfer-Gate 39; ein Kontaktbereich 347 für den Gate-Anschluss 247 des Auswahl-Schalters 47; ein Kontaktbereich 317 für die Spaltenleitung 17; ein Kontaktbereich 345 für den Gate-Anschluss 245 des Rücksetz-Schalters 45; ein Kontaktbereich 371 zum Anschlie-ßen des Überlauf-Kondensators 71 (in Fig. 11 und 12 nicht dargestellt); ein Kontaktbereich 373 für den Gate-Anschluss 273 des weiteren Transfer-Gate 73; eine Kontaktbahn 351, welche die beiden Anschlüsse VDD für die Versorgungsspannung 51 gemäß Fig. 11 miteinander verbindet; und ein Kontaktbereich 352 für die Masseleitung GND. Die genannten Metallisierungen gemäß Fig. 12 können mit den zugehörigen Elementen gemäß Fig. 11 über vertikale Durchkontaktierungen elektrisch verbunden sein, d.h. über Metallbahnen, die senkrecht zu der ersten, unteren Ebene gemäß Fig. 11 und der zweiten, oberen Ebene gemäß Fig. 12 durch den elektrischen Isolator (z.B. Siliziumdioxid) hindurch verlaufen.

Der Ausleseknoten 41 des Pixels 11 gemäß Fig. 11 und 12 umfasst einen Brückenabschnitt 341, der den Ausgang des Transfer-Gate 39 mit dem Gate-Anschluss 244 des Wandler-Transistors 43 verbindet. Der Brückenabschnitt 341 verläuft als Metallbahn in der zweiten, oberen Ebene des Pixels 11 gemäß Fig. 12 und überquert den Signalausgang 44 des Wandler-Transistors 43 und die Ausgangsleitung 144. Ein erstes Ende des Brückenabschnitts 341 ist über eine erste metallische Durchkontaktierung, die wiederum senkrecht zu der ersten und zweiten Ebene des Pixels 11 verläuft, mit dem Ausgang des Transfer-Gate 39 elektrisch verbunden; und ein zweites Ende des Brückenabschnitts ist über eine zweite metallische Durchkontaktierung, die wiederum senkrecht zu der ersten und zweiten Ebene des Pixels 11 verläuft, mit dem Gate-Anschluss 244 des Wandler-Transistors 43 elektrisch verbunden (s. die Bezeichnungen FD in Fig. 12).

Die Abschirmstruktur 61 des Pixels 11 gemäß Fig. 11 und 12 umfasst einen Abschirmabschnitt 361, der in der zweiten, oberen Ebene des Pixels 11 gemäß Fig. 12 verläuft. Der Abschirmabschnitt 361 umgibt den Brückenabschnitt 341 des Ausleseknotens 41 in der Form eines umfänglich geschlossenen Rings, der in derselben Ebene verläuft wie der Brückenabschnitt 341. Der Abschirmabschnitt 361 überdeckt den Ausgang des Transfer-Gate 39, den Signalausgang 44 des Wandler-Transistors 43 und die Ausgangsleitung 144 teilweise. Der Abschirmabschnitt 361 ist durch eine Metallbahn gebildet und ist über eine dritte metallische Durchkontaktierung, die wiederum senkrecht zu der ersten und zweiten Ebene des Pixels 11 verläuft, mit dem Signalausgang 44 des Wandler-Transistors 43 bzw. mit der Ausgangsleitung 144, welche den Signalausgang 44 mit dem Auswahl-Schalter 47 verbindet, elektrisch verbunden. Diese dritte metallische Durchkontaktierung bildet somit die bereits genannte Verbindungsleitung 63, welche einen Teil der Abschirmstruktur 61, nämlich den Abschirmabschnitt 361, mit dem Signalausgang 44 des Wandler-Transistors 43 bzw. mit der Ausgangsleitung 144 verbindet, und zwar in vertikaler Richtung. Da die erste Ebene und die zweite Ebene des Pixels 11 in geringem Abstand zueinander verlaufen (ungefähr in der Größenordnung der horizontalen Ausdehnung des Pixels 11), ist die (vertikale) Verbindungsleitung 63 bei diesem Ausführungsbeispiel relativ kurz.

Hierdurch sind die Abschirmstruktur 61 und insbesondere der Abschirmabschnitt 361 auf ein elektrisches Potential gesetzt, das von dem Spannungssignal des Wandler-Transistors 43 abhängt. Bezogen auf eine kürzeste Strecke, die von dem Ausgang des Transfer-Gate 39 zu dem Gate-Anschluss 244 des Wandler-Transistors 43 gezogen werden kann (vgl. Fig. 12), umgibt der ringförmige Abschirmabschnitt 361 mehr als die Hälfte dieser Strecke, nämlich den gesamten in der zweiten, oberen Ebene verlaufenden Brückenabschnitt 341.

Durch die in Fig. 11 und 12 gezeigte Anordnung der Komponenten des Pixels 11 kann eine geringe Ausdehnung des Ausleseknotens 41 erreicht werden, mit einer entsprechend geringen Kapazität. Das Transfer-Gate 39 und der Wandler-Transistor 43 können in geringem Abstand zueinander in einer gemeinsamen Ebene des Pixels 11 (erste Ebene gemäß Fig. 11) angeordnet sein. Indem der Brückenabschnitt 341 des Ausleseknotens 41 und somit ein wesentlicher Teil des Ausleseknotens 41 seitlich vollständig von dem ringförmigen Abschirmabschnitt 361 umgeben ist und dieser auf das elektrische Potential am Signalausgang 44 des Wandler-Transistors 43 gesetzt ist, wird die effektive Kapazität des Ausleseknotens 41 verringert. Eine weitere Verringerung der effektiven Kapazität des Ausleseknotens 41 wird dadurch erzielt, dass der Brückenabschnitt 341 des Ausleseknotens 41 den Signalausgang 44 des Wandler-Transistors 43 und die Ausgangsleitung 144 überquert und dass der Signalausgang 44 des Wandler-Transistors 43 und die hiermit verbundene Ausgangsleitung 144 somit als zusätzlicher Teil der Abschirmstruktur 61 wirken, welcher den Brückenabschnitt 341 des Ausleseknotens 41 an dessen Unterseite teilweise umgibt.

Noch eine weitere Verringerung der effektiven Kapazität des Ausleseknotens 41 wird dadurch erzielt, dass die Abschirmstruktur 61 weitere Abschirmabschnitte 261 umfasst, die in der ersten, unteren Ebene des Pixels 11 gemäß Fig. 11 benachbart zu dem Wandler-Transistor 43 verlaufen. Die weiteren Abschirmabschnitte 261 können ebenso wie der Signalausgang 44 des Wandler-Transistors 43 und die Ausgangsleitung 144 durch eine Dotierung des verwendeten Halbleitersubstrats gebildet sein. Die weiteren Abschirmabschnitte 261 bilden die Form eines jeweiligen Fingers, der geradlinig oder gekrümmt mit einem freien Ende von dem Signalausgang 44 des Wandler-Transistors 43 wegragt.

Bei dem in Fig. 11 gezeigten Ausführungsbeispiel verläuft der jeweilige weitere Abschirmabschnitt 261 parallel und eng benachbart zu dem Durchlasskanal 243 des Wandler-Transistors 43 (vgl. Fig. 11). Die beiden weiteren Abschirmabschnitte 261 bilden somit gemeinsam mit dem Signalausgang 44 des Wandler-Transistors 43 eine C-Form, die den Wandler-Transistor 43 und insbesondere dessen Durchgangskanal 243 und dessen Gate-Anschluss 244 an drei Seiten umgibt. Ferner verläuft der jeweilige weitere Abschirmabschnitt 261 parallelversetzt und gleichgerichtet zu einem Teil des ringförmigen, in der zweiten Ebene des Pixels 11 liegenden Abschirmabschnitts 361 (vgl. Fig. 12). Ein weiterer Abschirmabschnitt 261 könnte beispielsweise auch als fingerförmige Verlängerung von dem Signalausgang 44 des Wandler-Transistors 43 in Richtung des Transfer-Gate 39 wegragen (in Fig. 11 nicht gezeigt).

Durch die Kombination dieser Maßnahmen (ringförmiger Abschirmabschnitt 361 in der zweiten, oberen Ebene und ein oder mehrere weitere Abschirmabschnitt(e) 261 in der ersten, unteren Ebene des Pixels 11) wird eine besonders signifikante Verringerung der effektiven Kapazität des Ausleseknotens 41 erreicht.

### Bezugszeichenliste

- 11: Pixel
- 15, 15a, 15b: lichtempfindliches Element
- 17: Spaltenleitung
- 31: Stromquelle
- 33: Trennschalter
- 39: Transfer-Gate
- 41: Ausleseknoten
- 42: parasitäre Kapazität des Ausleseknotens
- 43: Wandler-Transistor
- 44: Signalausgang des Wandler-Transistors
- 45: Rücksetz-Schalter
- 47: Auswahl-Schalter
- 51: Versorgungsspannung
- 61, 61': Abschirmstruktur
- 62: Kapazität der Abschirmstruktur
- 63, 63': Verbindungsleitung
- 66: Isolierabstand
- 71: Überlauf-Kondensator
- 73: weiteres Transfer-Gate
- 113: Spaltenausleseschaltung
- 115: Vorladeschaltung
- 127: Referenzwert-Kondensator
- 131: Verstärker
- 133: Signalwert-Kondensator
- 135: positiver Eingang
- 137: negativer Eingang
- 144: Ausgangsleitung
- 147: Koppel-Schalter
- 149D, 149E: Schalter
- 153: Steuereinrichtung
- 160: Entkopplungsschaltung
- 162: Impedanzwandler
- 163: Verbindungsleitung
- 165: Massepotential
- 166: Schalter
- 167: Kondensator
- 168: Kondensator
- 171: weiterer Koppel-Schalter
- 239: Durchlasskanal des Transfer-Gate
- 240: Gate-Anschluss des Transfer-Gate
- 243: Durchlasskanal des Wandler-Transistors
- 244: Gate-Anschluss des Wandler-Transistors
- 245: Gate-Anschluss des Rücksetz-Schalters
- 247: Gate-Anschluss des Auswahl-Schalters
- 261: weiterer Abschirmabschnitt der Abschirmstruktur
- 273: Gate-Anschluss des weiteren Transfer-Gate
- 317: Kontaktbereich für die Spaltenleitung
- 340: Kontaktbereich für das Transfer-Gate
- 341: Brückenabschnitt des Ausleseknotens
- 345: Kontaktbereich für den Rücksetz-Schalter
- 347: Kontaktbereich für den Auswahl-Schalter
- 351: Kontaktbahn für die Versorgungsspannung
- 352: Kontaktbereich für die Masseleitung
- 361: Abschirmabschnitt der Abschirmstruktur
- 371: Kontaktbereich für den Überlauf-Kondensator
- 373: Kontaktbereich für das weitere Transfer-Gate

## Patentansprüche

1. Bildsensor, insbesondere CMOS-Bildsensor, für elektronische Kameras, mit einer Vielzahl von Pixeln (11) zur Erzeugung von belichtungsabhängigen Signalen, wobei ein jeweiliges Pixel (11) zumindest umfasst:
- ein lichtempfindliches Element (15), um aus einfallendem Licht elektrische Ladung zu erzeugen,
- einen Ausleseknoten (41),
- ein Transfer-Gate (39), um wahlweise das lichtempfindliche Element mit dem Ausleseknoten (41) zu koppeln,
- einen Wandler-Transistor (43), um die an dem Ausleseknoten (41) vorhandene Ladung in ein Spannungssignal an einem Signalausgang (44) umzusetzen, und
- einen Auswahl-Schalter (47), der mit dem Signalausgang (44) des Wandler-Transistors (43) verbunden ist, um den Signalausgang (44) des Wandler-Transistors (43) wahlweise mit einer zugeordneten Ausleseleitung (17) des Bildsensors zu koppeln;
wobei das jeweilige Pixel (11) eine elektrisch leitende Abschirmstruktur (61) aufweist, die den Ausleseknoten (41) zumindest teilweise umgibt und die auf ein elektrisches Potential gesetzt oder setzbar ist, das von dem Spannungssignal an dem Signalausgang (44) des Wandler-Transistors (43) abhängt,
wobei der Ausleseknoten (41) einen Brückenabschnitt (341) umfasst, der einen Ausgang des Transfer-Gate (39) mit einem Gate-Anschluss (244) des Wandler-Transistors (43) verbindet, wobei das Transfer-Gate (39) und der Wandler-Transistor (43) in einer ersten Ebene des Pixels (11) liegen und der Brückenabschnitt (341) in einer zweiten Ebene des Pixels (11) liegt, die relativ zu der ersten Ebene parallelversetzt ist, und wobei die Abschirmstruktur (61) einen Abschirmabschnitt (361) umfasst, der in der zweiten Ebene des Pixels (11) liegt und den Brückenabschnitt (341) zumindest teilweise umgibt,
**dadurch gekennzeichnet,**
- **dass** der Abschirmabschnitt (361) den Ausgang des Transfer-Gate (39) zumindest teilweise überdeckt und den Signalausgang (44) des Wandler-Transistors (43) zumindest teilweise überdeckt; und/oder
- **dass** die Abschirmstruktur (61) einen weiteren Abschirmabschnitt (261) umfasst, der in der ersten Ebene des Pixels (11) liegt und der benachbart zu dem Transfer-Gate (39) und/oder zu dem Wandler-Transistor (43) angeordnet ist.

2. Bildsensor nach Anspruch 1,
wobei die Abschirmstruktur (61) direkt oder indirekt mit dem Signalausgang (44) des Wandler-Transistors (43) verbunden oder koppelbar ist;
und/oder
wobei der Auswahl-Schalter (47) mit dem Signalausgang (44) des Wandler-Transistors (43) des jeweiligen Pixels (11) über eine Ausgangsleitung (144) verbunden ist und wobei die Abschirmstruktur (61) über die Ausgangsleitung (144) mit dem Signalausgang (44) des Wandler-Transistors (43) verbunden ist.

3. Bildsensor nach Anspruch 1 oder 2,
wobei der Brückenabschnitt (341) über eine erste Durchkontaktierung, die senkrecht zu der ersten Ebene des Pixels (11) verläuft, mit dem Ausgang des Transfer-Gate (39) verbunden ist, und wobei der Brückenabschnitt (341) über eine zweite Durchkontaktierung, die senkrecht zu der ersten Ebene des Pixels (11) verläuft, mit dem Gate-Anschluss (244) des Wandler-Transistors (43) verbunden ist.

4. Bildsensor nach einem der vorhergehenden Ansprüche,
wobei der Brückenabschnitt (341) den Signalausgang (44) des Wandler-Transistors (43) überquert.

5. Bildsensor nach einem der vorhergehenden Ansprüche,
wobei ein Durchlasskanal (239) des Transfer-Gate (39) und ein Durchlasskanal (243) des Wandler-Transistors (43) durch einen elektrisch leitenden Kanal eines Halbleitersubstrats gebildet sind, und wobei der Brückenabschnitt (341) durch eine Metallbahn auf dem Halbleitersubstrat gebildet ist.

6. Bildsensor nach Anspruch 5,
wobei der Bildsensor als ein rückwärtig belichteter Bildsensor ausgebildet ist, wobei die erste Ebene des Pixels (11) durch das Halbleitersubstrat gebildet ist und die zweiten Ebene des Pixels (11) durch die Metallbahn gebildet ist, wobei die erste Ebene des Pixels (11) und die zweiten Ebene des Pixels (11) durch eine Schicht eines elektrischen Isolators voneinander getrennt sind.

7. Bildsensor nach einem der vorhergehenden Ansprüche,
wobei der Abschirmabschnitt (361) einen umfänglich geschlossenen Ring bildet, der innerhalb der zweiten Ebene des Pixels (11) den Brückenabschnitt (341) umgibt.

8. Bildsensor nach einem der vorhergehenden Ansprüche,
wobei der Abschirmabschnitt (361) über eine dritte Durchkontaktierung, die senkrecht zu der ersten Ebene des Pixels (11) verläuft, mit dem Signalausgang (44) des Wandler-Transistors (43) verbunden ist.

9. Bildsensor nach einem der vorhergehenden Ansprüche,
wobei der weitere Abschirmabschnitt (261) einen länglichen Finger bildet, der ein freies Ende aufweist;
und/oder
wobei der weitere Abschirmabschnitt (261) parallel zu einem Durchlasskanal (243) des Wandler-Transistors (43) verläuft;
und/oder
wobei der weitere Abschirmabschnitt (261) parallelversetzt und gleichgerichtet zu einem Teil des in der zweiten Ebene des Pixels (11) liegenden Abschirmabschnitts (361) verläuft.

10. Bildsensor nach einem der vorhergehenden Ansprüche,
wobei die Abschirmstruktur (61) mehr als die Hälfte einer kürzesten Strecke umgibt, die von einem Ausgangs des Transfer-Gate (39) zu einem Eingang des Wandler-Transistors (43) verläuft.

11. Bildsensor nach einem der Ansprüche 1 bis 7,
wobei die Abschirmstruktur (61) über die zugeordnete Ausleseleitung (17) des Bildsensors und den Auswahl-Schalter (47) mit dem Signalausgang (44) des Wandler-Transistors (43) koppelbar ist.

12. Bildsensor nach Anspruch 11,
wobei die Abschirmstruktur (61) über einen Impedanzwandler (162) mit der zugeordneten Ausleseleitung (17) des Bildsensors verbunden oder koppelbar ist;
wobei der Impedanzwandler (162) insbesondere dazu ausgebildet ist, das Spannungssignal des Wandler-Transistors (43) zu verstärken;
wobei der Impedanzwandler (162) vorzugsweise dazu ausgebildet ist, das Spannungssignal des Wandler-Transistors (43) mit einer schaltbaren Verstärkung und/oder einer abnehmenden Verstärkungskennlinie zu verstärken.

13. Bildsensor nach einem der vorhergehenden Ansprüche,
wobei die Abschirmstruktur (61) über einen Koppel-Schalter (147) direkt oder indirekt mit dem Signalausgang (44) des Wandler-Transistors (43) koppelbar ist, wobei der Bildsensor insbesondere dazu ausgebildet, dass der Koppel-Schalter (147) gemeinsam mit dem Auswahl-Schalter (47) des jeweiligen Pixels angesteuert wird;
und/oder
wobei die Abschirmstruktur (61) über einen weiteren Koppel-Schalter (171) mit einem elektrischen Bezugspotential koppelbar ist.

14. Bildsensor nach einem der vorhergehenden Ansprüche,
wobei das jeweilige Pixel (11) ferner umfasst:
- einen Überlauf-Kondensator (71), und
- ein weiteres Transfer-Gate (73), um wahlweise den Ausleseknoten (41) mit dem Überlauf-Kondensator (71) zu koppeln.

## Claims

1. An image sensor, in particular a CMOS image sensor, for electronic cameras, the image sensor comprising a plurality of pixels (11) for generating exposure-dependent signals, wherein a respective pixel (11) at least comprises:
- a light-sensitive element (15) to generate electrical charge from incident light;
- a readout node (41);
- a transfer gate (39) to selectively couple the light-sensitive element to the readout node (41);
- a converter transistor (43) to convert the charge present at the readout node (41) into a voltage signal at a signal output (44); and
- a selection switch (47) which is connected to the signal output (44) of the converter transistor (43) to selectively couple the signal output (44) of the converter transistor (43) to an associated readout line (17) of the image sensor,
wherein the respective pixel (11) has an electrically conductive shielding structure (61) which at least partly surrounds the readout node (41) and which is set or can be set to an electrical potential which depends on the voltage signal at the signal output (44) of the converter transistor (43), wherein the readout node (41) comprises a bridge section (341) which connects an output of the transfer gate (39) to a gate terminal (244) of the converter transistor (43), wherein the transfer gate (39) and the converter transistor (43) are disposed in a first plane of the pixel (11) and the bridge section (341) is disposed in a second plane of the pixel (11) which is offset in parallel relative to the first plane, and wherein the shielding structure (61) comprises a shielding section (361) which is disposed in the second plane of the pixel (11) and which at least partly surrounds the bridge section (341),
**characterized in that**
- the shielding section (361) at least partly covers the output of the transfer gate (39) and at least partly covers the signal output (44) of the converter transistor (43); and/or
- **in that** the shielding structure (61) comprises a further shielding section (261) which is disposed in the first plane of the pixel (11) and which is arranged adjacent to the transfer gate (39) and/or to the converter transistor (43).

2. An image sensor in accordance with claim 1,
wherein the shielding structure (61) is directly or indirectly connected or couplable to the signal output (44) of the converter transistor (43);
and/or
wherein the selection switch (47) is connected to the signal output (44) of the converter transistor (43) of the respective pixel (11) via an output line (144), and wherein the shielding structure (61) is connected to the signal output (44) of the converter transistor (43) via the output line (144).

3. An image sensor in accordance with claim 1 or claim 2,
wherein the bridge section (341) is connected to the output of the transfer gate (39) via a first via which extends perpendicular to the first plane of the pixel (11), and wherein the bridge section (341) is connected to the gate terminal (244) of the converter transistor (43) via a second via which extends perpendicular to the first plane of the pixel (11).

4. An image sensor in accordance with any one of the preceding claims, wherein the bridge section (341) crosses the signal output (44) of the converter transistor (43).

5. An image sensor in accordance with any one of the preceding claims, wherein a current passage (239) of the transfer gate (39) and a current passage (243) of the converter transistor (43) are formed by an electrically conductive channel of a semiconductor substrate, and wherein the bridge section (341) is formed by a metal track on the semiconductor substrate.

6. An image sensor in accordance with claim 5,
wherein the image sensor is configured as a back side illuminated image sensor, wherein the first plane of the pixel (11) is formed by the semiconductor substrate and the second plane of the pixel (11) is formed by the metal track, wherein the first plane of the pixel (11) and the second plane of the pixel (11) are separated from one another by a layer of an electrical insulator.

7. An image sensor in accordance with any one of the preceding claims, wherein the shielding section (361) forms a circumferentially closed ring which surrounds the bridge section (341) within the second plane of the pixel (11).

8. An image sensor in accordance with any one of the preceding claims, wherein the shielding section (361) is connected to the signal output (44) of the converter transistor (43) via a third via which extends perpendicular to the first plane of the pixel (11).

9. An image sensor in accordance with any one of the preceding claims,
wherein the further shielding section (261) forms an elongate finger which has a free end;
and/or
wherein the further shielding section (261) extends in parallel with a current passage (243) of the converter transistor (43);
and/or
wherein the further shielding section (261) extends offset in parallel from and in the same direction as a part of the shielding section (361) disposed in the second plane of the pixel (11).

10. An image sensor in accordance with any one of the preceding claims,
wherein the shielding structure (61) surrounds more than half of a path of minimum length which extends from an output of the transfer gate (39) to an input of the converter transistor (43).

11. An image sensor in accordance with any one of the claims 1 to 7,
wherein the shielding structure (61) can be coupled to the signal output (44) of the converter transistor (43) via the associated readout line (17) of the image sensor and via the selection switch (47).

12. An image sensor in accordance with claim 11,
wherein the shielding structure (61) is connected or can be coupled to the associated readout line (17) of the image sensor via an impedance converter (162);
wherein the impedance converter (162) is in particular configured to amplify the voltage signal of the converter transistor (43);
wherein the impedance converter (162) is preferably configured to amplify the voltage signal of the converter transistor (43) with a switchable gain and/or a decreasing gain characteristic.

13. An image sensor in accordance with any one of the preceding claims,
wherein the shielding structure (61) can be directly or indirectly coupled to the signal output (44) of the converter transistor (43) via a coupling switch (147), wherein the image sensor is in particular configured such that the coupling switch (147) is controlled together with the selection switch (47) of the respective pixel;
and/or
wherein the shielding structure (61) can be coupled to an electrical reference potential via a further coupling switch (171).

14. An image sensor in accordance with any one of the preceding claims,
wherein the respective pixel (11) further comprises:
- an overflow capacitor (71); and
- a further transfer gate (73) to selectively couple the readout node (41) to the overflow capacitor (71).

## Revendications

1. Capteur d'images, en particulier capteur d'images CMOS, pour des caméras électroniques, comportant une multitude de pixels (11) pour générer des signaux dépendant de l'exposition, un pixel respectif (11) comprenant au moins :
- un élément photosensible (15) pour générer une charge électrique à partir de la lumière incidente,
- un noeud de lecture (41),
- une grille de transfert (39) pour coupler sélectivement l'élément photosensible au noeud de lecture (41),
- un transistor de conversion (43) pour convertir la charge, présente au niveau du noeud de lecture (41), en un signal de tension à une sortie de signal (44), et
- un commutateur de sélection (47) relié à la sortie de signal (44) du transistor de conversion (43) pour coupler sélectivement la sortie de signal (44) du transistor de conversion (43) à une ligne de lecture associée (17) du capteur d'images ;
dans lequel
le pixel respectif (11) présente une structure de blindage électriquement conductrice (61) qui entoure au moins partiellement le noeud de lecture (41) et qui est mise ou peut être mise à un potentiel électrique qui dépend du signal de tension à la sortie de signal (44) du transistor de conversion (43), le noeud de lecture (41) comprend une section de pont (341) reliant une sortie de la grille de transfert (39) à une borne de grille (244) du transistor de conversion (43), la grille de transfert (39) et le transistor de conversion (43) étant situés dans un premier plan du pixel (11) et la section de pont (341) étant située dans un deuxième plan du pixel (11), qui est décalé parallèlement par rapport au premier plan, et la structure de blindage (61) comprenant une section de blindage (361) qui se trouve dans le deuxième plan du pixel (11) et qui entoure au moins partiellement la section de pont (341),
**caractérisé en ce que**
- la section de blindage (361) recouvre au moins partiellement la sortie de la grille de transfert (39) et recouvre au moins partiellement la sortie de signal (44) du transistor de conversion (43) ; et/ou
- la structure de blindage (61) comprend une autre section de blindage (261) qui est située dans le premier plan du pixel (11) et qui est disposée de manière adjacente à la grille de transfert (39) et/ou au transistor de conversion (43).

2. Capteur d'images selon la revendication 1,
dans lequel la structure de blindage (61) est reliée ou peut être couplée directement ou indirectement à la sortie de signal (44) du transistor de conversion (43) ; et/ou
le commutateur de sélection (47) est relié à la sortie de signal (44) du transistor de conversion (43) du pixel respectif (11) par une ligne de sortie (144), et la structure de blindage (61) est reliée à la sortie de signal (44) du transistor de conversion (43) par la ligne de sortie (144).

3. Capteur d'images selon la revendication 1 ou 2,
dans lequel la section de pont (341) est reliée à la sortie de la grille de transfert (39) par l'intermédiaire d'un premier via qui s'étend perpendiculairement au premier plan du pixel (11), et la section de pont (341) est reliée à la borne de grille (244) du transistor de conversion (43) par l'intermédiaire d'un deuxième via qui s'étend perpendiculairement au premier plan du pixel (11).

4. Capteur d'images selon l'une des revendications précédentes,
dans lequel la section de pont (341) traverse la sortie de signal (44) du transistor de conversion (43).

5. Capteur d'images selon l'une des revendications précédentes,
dans lequel un canal de passage (239) de la grille de transfert (39) et un canal de passage (243) du transistor de conversion (43) sont formés par un canal électriquement conducteur d'un substrat semi-conducteur, et la section de pont (341) est formée par une piste métallique sur le substrat semi-conducteur.

6. Capteur d'images selon la revendication 5,
dans lequel le capteur d'images est réalisé sous forme de capteur d'images rétro-exposé, le premier plan du pixel (11) étant formé par le substrat semi-conducteur et le deuxième plan du pixel (11) étant formé par la piste métallique, le premier plan du pixel (11) et le deuxième plan du pixel (11) étant séparés l'un de l'autre par une couche d'un isolant électrique.

7. Capteur d'images selon l'une des revendications précédentes,
dans lequel la section de blindage (361) constitue un anneau périphériquement fermé qui entoure la section de pont (341) dans le deuxième plan du pixel (11).

8. Capteur d'images selon l'une des revendications précédentes,
dans lequel la section de blindage (361) est reliée à la sortie de signal (44) du transistor de conversion (43) par l'intermédiaire d'un troisième via qui s'étend perpendiculairement au premier plan du pixel (11).

9. Capteur d'images selon l'une des revendications précédentes,
dans lequel l'autre section de blindage (261) constitue un doigt allongé ayant une extrémité libre ;
et/ou
l'autre section de blindage (261) s'étend parallèlement à un canal de passage (243) du transistor de conversion (43) ;
et/ou
l'autre section de blindage (261) est décalée parallèlement et s'étend dans le même sens qu'une partie de la section de blindage (361) située dans le deuxième plan du pixel (11).

10. Capteur d'images selon l'une des revendications précédentes,
dans lequel la structure de blindage (61) entoure plus de la moitié d'un trajet le plus court allant d'une sortie de la grille de transfert (39) à une entrée du transistor de conversion (43).

11. Capteur d'images selon l'une des revendications 1 à 7,
dans lequel la structure de blindage (61) peut être couplée à la sortie de signal (44) du transistor de conversion (43) par l'intermédiaire de la ligne de lecture (17) associée du capteur d'images et par l'intermédiaire du commutateur de sélection (47).

12. Capteur d'images selon la revendication 11,
dans lequel la structure de blindage (61) est reliée ou peut être couplée à la ligne de lecture (17) associée du capteur d'images par l'intermédiaire d'un convertisseur d'impédance (162) ;
le convertisseur d'impédance (162) est en particulier réalisé pour amplifier le signal de tension du transistor de conversion (43) ;
le convertisseur d'impédance (162) est de préférence réalisé pour amplifier le signal de tension du transistor de conversion (43) avec une amplification commutable et/ou avec une courbe caractéristique d'amplification décroissante.

13. Capteur d'images selon l'une des revendications précédentes,
dans lequel la structure de blindage (61) peut être couplée directement ou indirectement à la sortie de signal (44) du transistor de conversion (43) par l'intermédiaire d'un commutateur de couplage (147), le capteur d'images étant en particulier réalisé pour que le commutateur de couplage (147) soit piloté conjointement avec le commutateur de sélection (47) du pixel respectif ;
et/ou
la structure de blindage (61) peut être couplée à un potentiel électrique de référence par l'intermédiaire d'un autre commutateur de couplage (171).

14. Capteur d'images selon l'une des revendications précédentes,
dans lequel le pixel respectif (11) comprend en outre :
- un condensateur de débordement (71), et
- une autre grille de transfert (73) pour coupler sélectivement le noeud de lecture (41) au condensateur de débordement (71).
